# EUROPEAN PATENT APPLICATION

(11) **EP 4 648 292 A1**
(43) Date of publication of application: **12.11.2025**
(21) Application number: 25175143.4
(22) Date of filing: 08.05.2025
(51) Int. Cl.: H03M 7/30, G06F 12/02, G06F 12/0802, G06F 9/50, G06F 12/04, G06T 1/20

(54) **DECOMPRESSION OF WORK ITEM COORDINATE DATA FOR WORK ITEMS IN A WORK GROUP**

(30) Priority: 10.05.2024 GB 202406638; 10.05.2024 GB 202406641
(71) Applicant: Imagination Technologies Limited, Kings Langley, Hertfordshire WD4 8LZ (GB)
(72) Inventor: De Lucas Casamayor, Enrique, Hertfordshire, WD4 8LZ (GB)
(74) Representative: Slingsby Partners LLP

(57) **Abstract**

A method for receiving compressed work item coordinate data for work items and decompressing it, each work item being identifiable with a swizzle index, the method comprising receiving a work item valid mask, the work item valid mask indicating valid work items; computing the swizzle index for each valid work item, as indicated by the work item valid mask; receiving a first swizzle mask, indicating which bits of the swizzle index for each work item correspond to the value of a first coordinate for that work item; receiving a second swizzle mask, indicating which bits of the swizzle index for each work item correspond to the value of a second coordinate for that work item; determining a first and a second coordinate for each valid work item in dependence on the first and second swizzle masks and the swizzle index computed for that valid work item.

## Description

### CROSS-REFERENCE TO RELATED APPLICATION

This application claims priority from UK patent application no. 2406641.7 filed on 10 May 2024 and UK patent application no. 2406638.3 also filed on 10 May 2024, both of which are herein incorporated by reference in their entirety.

### TECHNICAL FIELD

This application relates to techniques for compression and decompression of work item coordinate data. This can increase the rate of compute task scheduling in a computing system.

### BACKGROUND

In computing systems which may be used for graphics processing, computation is performed in order to process data such as graphics data. The computing system may include a Graphics Processing Unit (GPU). The GPU may be used to process graphics data, e.g. in order to render an image. Furthermore, a GPU may be used to process more general data (which may be referred to as 'compute data'), e.g. to perform general computation processes on the data. GPUs are particularly well suited for performing parallel processing, e.g. using a Single Instruction Multiple Data (SIMD) approach. The compute workload of the GPU is formed of tasks, each task being made up of a number of computational instances.

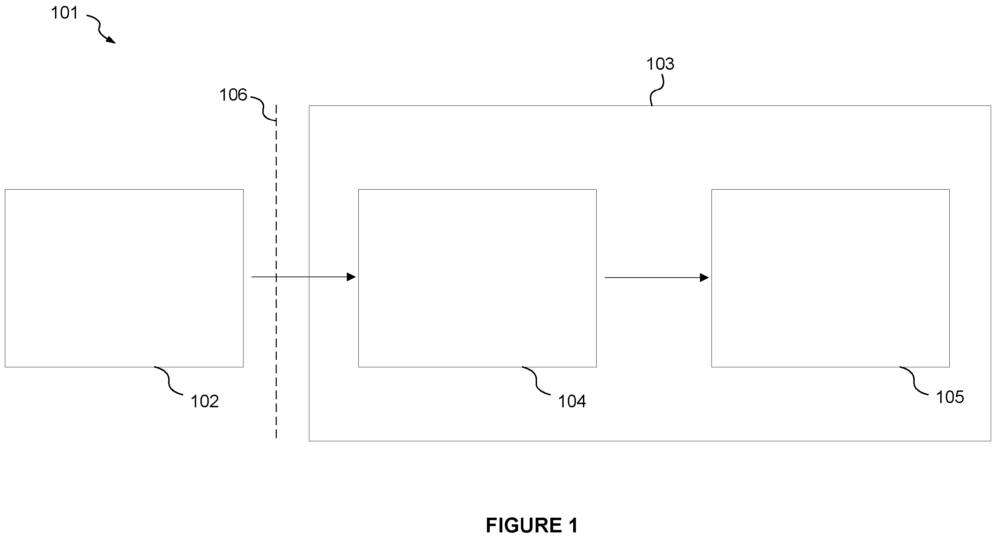

Figure 1 shows elements of a computing system which may be used for graphics processing, GPU 101. The GPU 101 includes several computation units. The GPU comprises a computation requesting unit 102 and processing logic 103. Processing logic 103 includes computation sequencing unit 104 and a computation execution unit 105. The computation requesting unit 102 may be referred to as a data master, e.g. a compute data master (CDM), the computation sequencing unit 104 may be referred to as a programmable data sequencer (PDS), and the computation execution unit 105 may be referred to as a unified shading cluster (USC). The interface between the computation requesting unit 102 and computation sequencing unit 104 is indicated by the dashed line 106. The computation execution unit 105 is configured to execute tasks, each task being made up of a plurality of instances. The computation sequencing unit 104 may be configured to receive requests for work to be performed from one or more computation requesting units (e.g. a compute data master requesting for compute work to be performed, a pixel data master requesting for pixel processing work to be performed, and/or a vertex data master requesting for vertex processing work to be performed). The computation sequencing unit 104 may be configured to determine a desired order of tasks to be executed and instruct the computation execution unit 105 to execute the tasks in the desired order as determined by the sequencing unit. The computation sequencing unit may be configured to determine a desired order of instances to be performed within each task and instruct the computation execution unit 105 to execute the instances in the desired order. In this way, the computation sequencing unit 104 assembles tasks and instructs the computation execution unit 105 to schedule and then perform the workload.

The computation requesting unit 102 is configured to request that computation is performed by the processing logic 103. In order to request that certain tasks or instances are executed by the processing logic 103, the computation requesting unit 102 sends across the interface information about work items. Work items are executed at the computation execution unit 105 as instances.

The rate at which instances can be scheduled and executed as part of the compute workload is therefore influenced by the rate at which information about work items can be sent across the interface between the computation requesting unit 102 and computation sequencing unit 104. It is thus desirable to develop a technique by which the rate at which work item information can be sent across the interface is improved, i.e. increased.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

According toa first embodiment there is provided a method for receiving compressed work item coordinate data for work items in a work group across an interface between a computation requesting unit and a computation sequencing unit and decompressing the compressed work item coordinate data, each work item in the work group being identifiable with a swizzle index, the method comprising receiving a work item valid mask from the computation requesting unit, the work item valid mask indicating valid work items in the work group; computing the swizzle index for each valid work item in the work group, as indicated by the work item valid mask; receiving a first swizzle mask from the computation requesting unit, the first swizzle mask indicating which bits of the swizzle index for each work item in the work group correspond to the value of a first coordinate for that work item; receiving a second swizzle mask from the computation requesting unit, the second swizzle mask indicating which bits of the swizzle index for each work item in the work group correspond to the value of a second coordinate for that work item; determining a first coordinate for each valid work item in dependence on the first swizzle mask and the swizzle index computed for that valid work item; and determining a second coordinate for each valid work item in dependence on the second swizzle mask and the swizzle index computed for that valid work item.

The work group may have a first dimension, the first coordinate of a work item indicating the position of the work item in the work group in the first dimension; and the work group may have a second dimension, the second coordinate of a work item indicating the position of the work item in the work group in the second dimension.

Each work item in the work group may be associated with a work item index, the work item indices indicating the order of work items in the work group.

The number of distinct work item positions within the work group in the first dimension may be a power of 2, and for each valid work item in the work group, computing the swizzle index for the valid work item may comprise setting the swizzle index as being equal to the work item index for that valid work item.

The number of distinct work item positions within the work group in the first dimension may not be a power of two.

Computing the swizzle index for each work item in the first work item position in the first dimension may comprise setting the swizzle index for a work item as being equal to the work item index for that work item in a reference work group, the reference work group having a number of distinct work item positions equal to the next power of 2 that is greater than the number of distinct work item positions within the work group.

For one or more of the valid work items in the work group, the swizzle index may be computed for that valid work item to be not equal to the work item index for that valid work item.

The swizzle index may be computed for each valid work item such that the swizzle index for a valid work item having a first coordinate of 0 and a second coordinate of Y, is determined to be YK, where K is the smallest power of two that is greater than xₘₐₓ, where xₘₐₓ is the maximum value of the first coordinates of the work items in the work group.

Determining a first coordinate for each valid work item in dependence on the first swizzle mask and the swizzle index computed for that valid work item may comprise determining the first coordinate for a valid work item as being the number represented by the bits of the swizzle index of that valid work item indicated by the first swizzle mask.

Determining a second coordinate for each valid work item in dependence on the second swizzle mask and the swizzle index computed for that valid work item may comprise determining the second coordinate for a valid work item as being the number represented by the bits of the swizzle index of that valid work item indicated by the second swizzle mask.

The method may comprise receiving the first swizzle mask and the second swizzle mask only once for each work group.

The work group may have a third dimension, wherein a third coordinate of a work item indicates the position of the work item in the work group in the third dimension, and wherein the method may comprise receiving a third swizzle mask indicating which bits of the swizzle index for each work item in the work group correspond to the value of the third coordinate for that work item; and determining a third coordinate for each for each valid work item in dependence on the third swizzle mask and the swizzle index computed for that valid work item by determining the third coordinate for a valid work item as being the number represented by the bits of the swizzle index of that valid work item indicated by the third swizzle mask.

The work item valid mask may indicate up to 64 valid work items the work group.

For a work group comprising more than a threshold number of work items, the method may comprise receiving a further work item valid mask; and computing the swizzle index for each valid work item in the work group, as indicated by the work item valid mask or the further work item valid mask.

The method may further comprise, for each valid work item in the work group, accessing the valid work item at the first and second coordinates and sequencing the computation of the valid work item.

According to a second embodiment there is provided processing logic configured to receive compressed work item coordinate data for work items in a work group across an interface from a computation requesting unit and decompress the compressed work item coordinate data, each work item in the work group being identifiable with a swizzle index, the processing logic being configured to receive a work item valid mask from the computation requesting unit, the work item valid mask indicating valid work items in the work group; compute the swizzle index for each valid work item in the work group, as indicated by the work item valid mask; receive a first swizzle mask from the computation requesting unit, the first swizzle mask indicating which bits of the swizzle index for each work item in the work group correspond to the value of a first coordinate for that work item; receive a second swizzle mask from the computation requesting unit, the second swizzle mask indicating which bits of the swizzle index for each work item in the work group correspond to the value of a second coordinate for that work item; determine a first coordinate for each valid work item in dependence on the first swizzle mask and the swizzle index computed for that valid work item; and determine a second coordinate for each valid work item in dependence on the second swizzle mask and the swizzle index computed for that valid work item.

The processing logic may comprise a computation sequencing unit and a computation execution unit, the computation sequencing unit being configured to receive a work item valid mask from the computation requesting unit, the work item valid mask indicating valid work items in the work group; compute the swizzle index for each valid work item in the work group, as indicated by the work item valid mask; receive a first swizzle mask from the computation requesting unit, the first swizzle mask indicating which bits of the swizzle index for each work item in the work group correspond to the value of a first coordinate for that work item; and receive a second swizzle mask from the computation requesting unit, the second swizzle mask indicating which bits of the swizzle index for each work item in the work group correspond to the value of a second coordinate for that work item; and the computation execution unit being configured to determine a first coordinate for each valid work item in dependence on the first swizzle mask and the swizzle index computed for that valid work item; and determine a second coordinate for each valid work item in dependence on the second swizzle mask and the swizzle index computed for that valid work item.

There is also provided a computing system comprising the processing logic described herein and a computation requesting unit, the computation requesting unit being configured to create the work item valid mask in dependence on the number of work items in the work group and the positions of work items in the work group, the work item valid mask indicating valid work items in the work group; compute the first swizzle mask indicating which bits of the index for each work item in the work group correspond to the value of a first coordinate for that work item; compute the second swizzle mask indicating which bits of the index for each work item in the work group correspond to the value of a second coordinate for that work item; and send the first and second swizzle masks and the work item valid mask across the interface to the computation sequencing unit.

There may additionally be provided a method for compressing work item coordinate data for work items in a work group and sending the compressed work item coordinate data across an interface between a computation requesting unit and a computation sequencing unit, each work item in the work group being identifiable with a swizzle index, the method comprising creating a work item valid mask in dependence on the number of work items in the work group and the positions of work items in the work group, the work item valid mask indicating valid work items in the work group; computing a first swizzle mask indicating which bits of the swizzle index for each work item in the work group correspond to the value of a first coordinate for that work item; computing a second swizzle mask indicating which bits of the swizzle index for each work item in the work group correspond to the value of a second coordinate for that work item; and sending the first and second swizzle masks and the work item valid mask across the interface to the computation sequencing unit.

The work group may have a first dimension, the first coordinate of a work item indicating the position of the work item in the work group in the first dimension; and the work group may have a second dimension, the second coordinate of a work item indicating the position of the work item in the work group in the second dimension.

Each of the swizzle masks may be computed in dependence on a size of the work group in one of the dimensions.

Computing the first swizzle mask may comprise determining a maximum value of the first coordinate for the work items in the work group to be equal to r-1, where r is the number of distinct work item positions within the work group in the first dimension.

Computing the second swizzle mask may comprise determining a maximum value of the second coordinate for the work items in the work group to be equal to z-1, where z is the number of distinct work item positions within the work group in the second dimension.

Computing the first swizzle mask may comprise assigning a first binary value to the m least significant bits of the first swizzle mask, wherein m is the number of bits required to represent the maximum value of the first coordinate for the work items in the work group; and assigning a second binary value to the remaining bits of the first swizzle mask, wherein the first binary value is different to the second binary value.

Computing the second swizzle mask may comprise assigning the first binary value to a contiguous set of p bits of the second swizzle mask, wherein p is the number of bits required to represent the maximum value of the second coordinate for the work items in the work group, and wherein the least significant bit of the contiguous set of p bits is the (m+1)th least significant bit of the second swizzle mask; and assigning the second binary value to the remaining bits of the second swizzle mask.

Computing the first swizzle mask may comprise assigning a first binary value to the m least significant even bits of the first swizzle mask, wherein m is the number of bits required to represent the maximum value of the first coordinate for the work items in the work group; and assigning a second binary value to the remaining bits of the first swizzle mask, wherein the first binary value is different to the second binary value.

Computing the second swizzle mask may comprise assigning the first binary value to the p least significant odd bits of the second swizzle mask, wherein p is the number of bits required to represent the maximum value of the second coordinate for the work items in the work group; and assigning the second binary value to the remaining bits of the second swizzle mask.

The number of distinct work item positions within the work group in the first dimension may be a power of 2.

The number of distinct work item positions within the work group in the first dimension may not be a power of 2.

Computing the first swizzle mask may comprise determining an augmented size of the work group in the first dimension as the smallest value that is a power of two and greater than the number of distinct work item positions within the work group in the first dimension; and computing the first swizzle mask in dependence on the augmented size of the work group in the first dimension.

Computing the second swizzle mask may comprise determining an augmented size of the work group in the second dimension as the smallest value that is a power of two and greater than the number of distinct work item positions within the work group in the second dimension; and computing the second swizzle mask in dependence on the augmented size of the work group in the second dimension.

The work group may have a third dimension, a third coordinate of a work item indicating the position of the work item in the work group in the third dimension, and the method may comprise computing a third swizzle mask indicating which bits of the swizzle index for each work item in the work group correspond to the value of the third coordinate for that work item.

The work group may have n dimensions, and the method may comprise computing an n^{th} swizzle mask indicating which bits of the swizzle index for each work item in the work group correspond to the value of an n^{th} coordinate for that work item.

The method may comprise sending the first and the second swizzle masks across the interface to the computation sequencing unit only once for each work group.

Creating the work item valid mask may comprise assigning a first binary value to each bit of the work item valid mask which corresponds to the position of a valid work item in the work group.

The valid work items in the work group may form a contiguous group of work items, and creating the work item valid mask may comprise assigning a first binary value to the q least significant bits of the work item valid mask, where q is the number of valid work items in the work group.

The work group may comprise more than a threshold number of work items, and the method may comprise creating a further work item valid mask in dependence on the number of work items in the work group and the positions of work items in the work group; and sending the further work item valid mask across the interface to the computation sequencing unit.

Each work item in the work group may be associated with a work item index, the work item indices indicating the order of work items in the work group.

The swizzle index for each work item may be equal to the work item index for that work item.

The swizzle index for each work item may not be equal to the work item index for that work item.

There may further be provided a computation requesting unit configured to compress work item coordinate data for work items in a work group and send the compressed work item coordinate data across an interface to a computation sequencing unit, each work item in the work group being identifiable with a swizzle index, the computation requesting unit being configured to create a work item valid mask in dependence on the number of work items in the work group and the positions of work items in the work group, the work item valid mask indicating valid work items in the work group; compute a first swizzle mask indicating which bits of the swizzle index for each work item in the work group correspond to the value of a first coordinate for that work item; compute a second swizzle mask indicating which bits of the swizzle index for each work item in the work group correspond to the value of a second coordinate for that work item; and send the first and second swizzle masks and the work item valid mask across the interface to the computation sequencing unit.

There may also be provided a computing system comprising the computation requesting unit and processing logic comprising the computation sequencing unit, the processing logic being configured to receive a work item valid mask from the computation requesting unit, the work item valid mask indicating valid work items in the work group; compute the swizzle index for each valid work item in the work group, as indicated by the work item valid mask; receive a first swizzle mask from the computation requesting unit, the first swizzle mask indicating which bits of the swizzle index for each work item in the work group correspond to the value of a first coordinate for that work item; receive a second swizzle mask from the computation requesting unit, the second swizzle mask indicating which bits of the swizzle index for each work item in the work group correspond to the value of a second coordinate for that work item; determine a first coordinate for each valid work item in dependence on the first swizzle mask and the swizzle index computed for that valid work item; and determine a second coordinate for each valid work item in dependence on the second swizzle mask and the swizzle index computed for that valid work item.

There is further provided computer readable code configured to cause any of the methods described herein to be performed when the code is run. There is also provided a computer readable storage medium having encoded thereon computer readable code configured to cause the methods described herein to be performed when the code is run.

There is also provided an integrated circuit definition dataset that, when processed in an integrated circuit manufacturing system, configures the integrated circuit manufacturing system to manufacture the processing logic or the computing systems described herein.

There is further provided a non-transitory computer readable storage medium having stored thereon a computer readable description of the processing logic or the computing systems described herein that, when processed in an integrated circuit manufacturing system, causes the integrated circuit manufacturing system to manufacture an integrated circuit embodying the processing logic or the computing systems.

There is also provided a method of manufacturing, using an integrated circuit manufacturing system, the processing logic or the computing systems described herein.

The computing system may be embodied in hardware on an integrated circuit. There may be provided a non-transitory computer readable storage medium having stored thereon a computer readable description of a computing system that, when processed in an integrated circuit manufacturing system, causes the integrated circuit manufacturing system to manufacture an integrated circuit embodying the described computing systems.

There may be provided an integrated circuit manufacturing system comprising: a non-transitory computer readable storage medium having stored thereon a computer readable description of the graphics processing system; a layout processing system configured to process the computer readable description so as to generate a circuit layout description of an integrated circuit embodying the computing systems; and an integrated circuit generation system configured to manufacture the computing system according to the circuit layout description.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

### BRIEF DESCRIPTION OF THE DRAWINGS

Examples will now be described in detail with reference to the accompanying drawings in which:
Figure 1 shows elements of a computing system.
Figure 2 shows a work group and the work item indices associated with work items of the work group.
Figure 3 shows a work group and two examples of work item indices that may be associated with work items of the work group.
Figure 4 shows a method for compressing work item coordinate data for work items in a work group and sending the compressed work item coordinate data across an interface between a computation requesting unit and a computation sequencing unit.
Figure 5 shows a work item valid mask.
Figure 6 shows a first swizzle mask and a second swizzle mask.
Figure 7 shows two sets of first and second swizzle masks.
Figure 8 shows a method for receiving compressed work item coordinate data and decompressing the compressed work item coordinate data.
Figure 9 shows a work group containing work items and the work item indices and swizzle indices associated with the work group.
Figure 10 shows swizzle masks and a swizzle index used to determine work item coordinates.
Figure 11 shows the swizzle indices and swizzle masks used to determine work item coordinates of a work group.
Figure 12 shows valid work items of a work group and a work item valid mask for the work group.
Figure 13 shows a work group, a work item valid mask and first and second swizzle masks associated with the work group.
Figure 14 shows a work group and work item indices and swizzle indices associated with the work group.
Figure 15 shows a three dimensional work group and three swizzle masks associated with the work group.
Figure 16 shows a computer system in which a computing system is implemented; and
Figure 17 shows an integrated circuit manufacturing system for generating an integrated circuit embodying a computing system.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

### DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

A GPU commonly includes a computation requesting unit, a computation sequencing unit and a computation execution unit. In order for the requesting unit to request that the computation execution unit executes tasks formed of a plurality of computational instances, the computation requesting unit is required to send information about work items to be executed to the computation execution unit via the computation sequencing unit. Conventional approaches to sending this data involve sending the coordinates for every work item within a work group to be executed across the interface between the computation requesting unit and the computation sequencing unit. Such approaches involve sending large amounts of data across the interface per cycle. It is generally desirable to keep the size of the interface small, to thereby keep the overall silicon area of the computing system low, and as such there is a limit to the rate at which the data can be sent across the interface. The rate at which instances are executed by the computation execution unit may be limited by the rate at which the computation requesting unit can send the work item coordinates across the interface to the computation sequencing unit. The techniques described herein provide an approach for compressing work item coordinate data at the computation requesting unit before sending the compressed data across the interface. The data can be decompressed by the computation sequencing and execution units to be used by the computation execution unit for execution of computational instances. The approaches described herein can reduce the amount of data required to be sent across the interface per cycle and therefore increase the rate at which data can be sent. The rate of computational execution can therefore be improved.

Embodiments will now be described by way of example only.

Returning to the GPU 101 seen in figure 1, the computation requesting unit 102 may be referred to as a compute data master. The computation sequencing unit 104 may be referred to as a programmable data sequencer. The GPU 101 may include other units besides those illustrated in figure 1. For example, GPU 101 may include one or more other requesting units configured to request computation from the processing logic 103. Other requesting units may include a pixel data master and a vertex data master.

The function of the computation sequencing unit 104 is to prioritise when tasks and instances should be executed and instruct the computation execution unit 105 to execute tasks and instances in an order which takes account of that prioritisation. The compute workload may include tasks which relate to processing any type of data, e.g. graphics data in order to generate image data.

In order to request that instances are executed by the processing logic 103, the computation requesting unit 102 sends work items corresponding to the requested instances to the processing logic 103. The work items are scheduled and then executed as instances by the computation sequencing unit 104 and computation execution unit 105. Work items are grouped into work groups. Work groups may be packed into tasks to be executed by the computation execution unit 105. As an example, a task may contain up to 128 instances from up to 8 work groups.

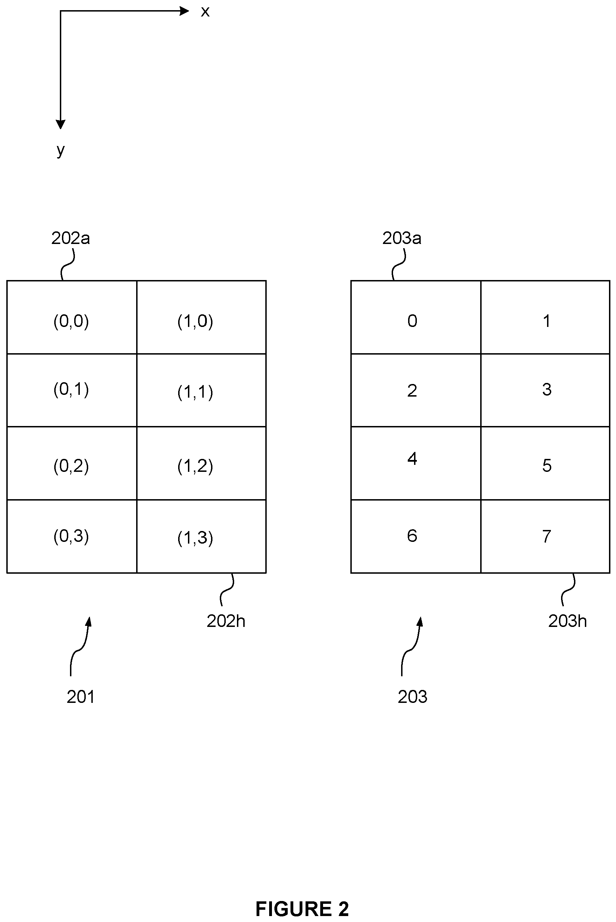

Figure 2 shows a work group 201 comprising a plurality of work items 202. In the example seen in figure 2, the work group comprises eight work items 202a to 202h. Only work items 202a and 202h are labelled in figure 2. The work group 202 seen in figure 2 is a two-dimensional (2D) work group. The work group 202 has a first dimension. In the following example, the first dimension is the x dimension. The work group 202 has a second dimension. In the following example, the second dimension is the y dimension. The work items in the work group may represent graphics data for an image being rendered by the GPU.

As illustrated in figure 2, each work item has a set of coordinates indicating its position within the work group. There are 8 distinct work item positions in work group 201. For example, work item 202a has coordinates (0,0). Work item 202h has coordinates (1,3). The first coordinate of the work item indicates the position of the work item in the work group in the first dimension. The second coordinate of the work item indicates the position of the work item in the work group in the - second dimension. The size of the first dimension is equal to the number of distinct work item positions within the work group in the first dimension. The size of the second dimension is equal to the number of distinct work item positions within the work group in the second dimension. The work group 201 seen in figure 2 has a first dimension of 2. There are two distinct work item positions in the x dimension. The work group 201 has a second dimension of 4. There are four distinct work item positions in the y dimension.

According to one example, each coordinate of a work item comprises 10 bits. Thus for the 2D work group 201, each work item has two coordinates which may be represented with 20 bits. For a 3D work group, each work item has three coordinates which may be represented with 30 bits.

Each work item 202 in the work group 201 is associated with a work item index 203 (203a to 203h). The work item indices 203 may indicate the order of work items in the work group. The work item index for a work item may be referred to as the work item ID. The number of work item indices 203 is therefore equal to the number of work items in the work group. In the example of figure 2, there are eight work item indices 203 associated with the work group. In the example seen in figure 2, the work item indices are assigned using a linear order. The work item index 203a is 0 and is associated with the work item 202a. The work item index 203h is 7 and is associated with the work item 202h.

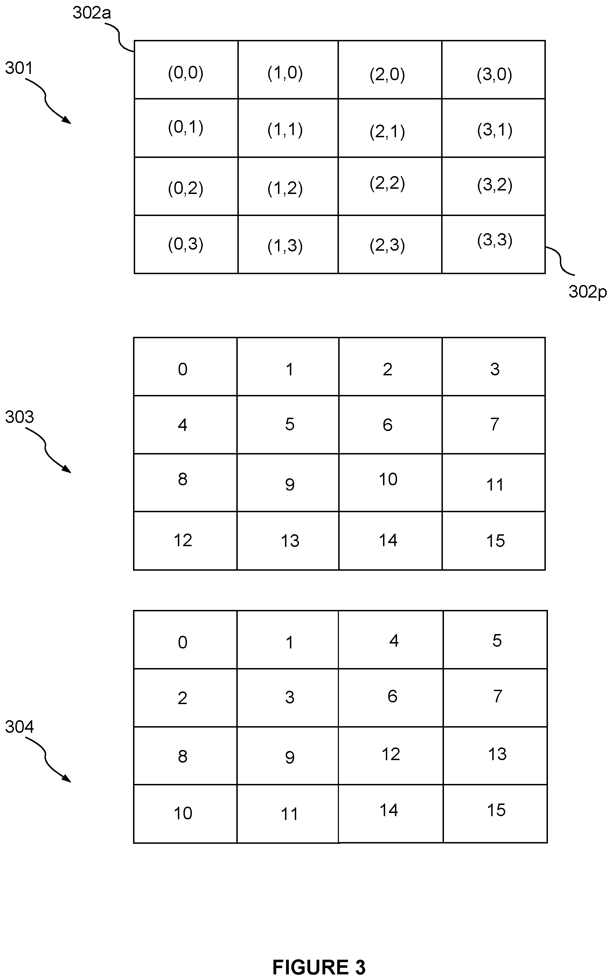

Figure 3 illustrates another example of a work group 301. The work group 301 comprises 16 work items 302a to 302p. Figure 3 illustrates that work item indices may be assigned to the work items in the work group using two different orders. As per figure 2, the work item indices 303 in Figure 3 are assigned using a linear order. Figure 3 also shows work item indices 304 which are assigned using a different order, a Morton order.

Existing methods for sending information about the work items in the work group across the interface 106 between a computation requesting unit 102 and a computation sequencing unit 104 involve sending the work item coordinates for every work item in the work group. Known methods involve the sending the coordinates of every work item required to execute each instance across the interface.

As mentioned above, the rate at which instances can be scheduled and executed by the processing logic 103 is influenced by the rate at which information about work items can be sent across the interface between the computation requesting unit 102 and computation sequencing unit 104. The rate at which the GPU can process data is therefore limited by the rate at which work item information can be sent across the interface 106.

According to existing approaches in which the coordinates for each work item are sent across the interface, work item information for only 1 work item is sent across the interface per clock cycle. Each coordinate of a work item comprises 10 bits. Thus for the 2D work group 201, the coordinates for each work item may comprise 20 bits. Sending the coordinates for one work item across the interface per cycle may therefore involve sending 20 bits across the interface per cycle. According to an example in which the work group is three-dimensional, sending the coordinates for one work item across the interface per cycle may involve sending 30 bits across the interface per cycle.

Sending one set of work item coordinates (i.e. the work item coordinates for one work item) per cycle, means that N transactions between the computation requesting unit 102 and computation sequencing unit 103 are needed for the execution of N instances. In other words, on average, only one instance may be executed per cycle. As an example, N may be 128. Thus for the execution of a task formed of 128 instances, at least 128 transactions would be needed to transfer all the necessary work item information.

Work item information for more work items could be sent across the interface per clock cycle by increasing the size of the interface (and optionally other interfaces and hardware structures within the GPU), however this would increase the size and associated cost of the GPU. Furthermore, because there is high homogeneity in the coordinates of work items in a single work group, sending the coordinates for every work item across the interface 106 means that redundant data may be sent in every cycle.

The inventors of the present invention have developed a method by which to increase the instance scheduling rate for compute workloads. Instead of separately sending the coordinates of every work item for every instance across the interface 106 between the computation requesting unit and the computation sequencing unit, the present invention involves compressing the work item coordinate data and sending compressed data across the interface. In particular, the present invention involves compressing the work item coordinate data for the work items of a work group and sending the compressed data across the interface. According to the present invention, the coordinates for each work item to be executed may be computed by the processing logic 103 upon receiving the compressed data. As will be explained in more detail below, use of this method means that fewer transactions between the computation requesting unit 102 and computation sequencing unit 103 are needed for the execution of the instances corresponding to the work items in a work group. Specifically, for the execution of a task formed of 128 instances, according to one example, 5 transactions are needed to transfer all the necessary work item information for the work group corresponding to the task.

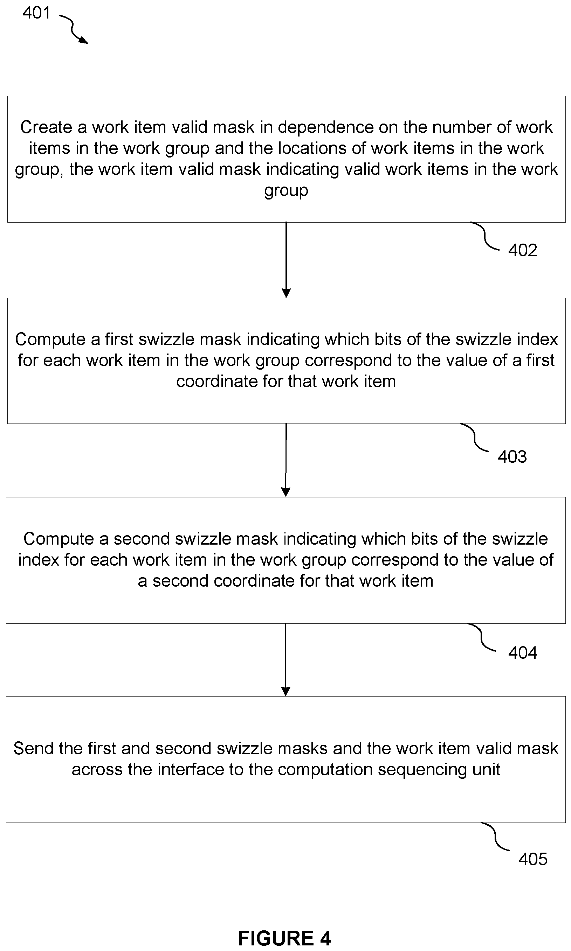

The method for compressing work item coordinate data for work items in the work group is shown in figure 4. The method 401 comprises: creating a work item valid mask in dependence on the number of work items in the work group and the locations of work items in the work group, the work item valid mask indicating valid work items in the work group (402); computing a first swizzle mask indicating which bits of a swizzle index for each work item in the work group correspond to the value of a first coordinate for that work item (403); and computing a second swizzle mask indicating which bits of a swizzle index for each work item in the work group correspond to the value of a second coordinate for that work item (404). The method 401 is performed by the computation requesting unit 102.

As will be explained in more detail below, work groups may have more than two dimensions. Therefore according to other examples, compressing work item coordinate data may involve computing more than two swizzle masks. Generally, for a work group having n dimensions, compressing the work item coordinate data may comprise computing n swizzle masks, each of the swizzle masks indicating which bit(s) of the swizzle index for each work item in the work group correspond to the value of a respective one of the n coordinates for that work item. The method seen in figure 4 may therefore be extended for a work group having n dimensions. The method may include additional steps for computing n swizzle masks. The method may include sending the computed n swizzle masks across the interface to the computation sequencing unit.

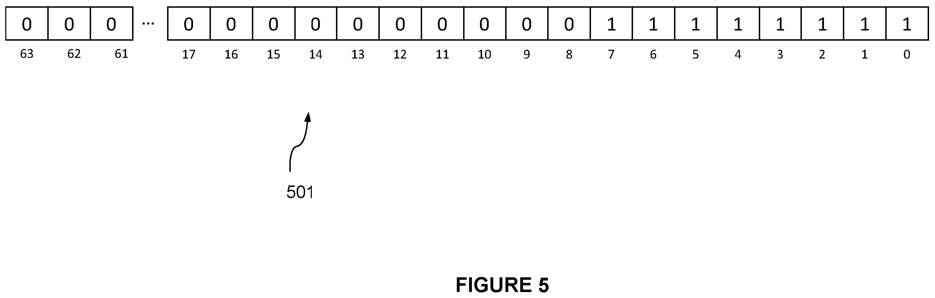

Figure 5 illustrates a work item valid mask 501 created for the work items 202 in the work group 201 seen in figure 2. The work item valid mask 501 seen in figure 5 comprises 64 bits. Each bit of the work item valid mask indicates whether or not a respective work item in the work group is valid. The work item valid mask 501 thus indicates up to 64 valid work items in the work group. According to another example, the work item valid mask may indicate more or fewer work items in the work group. For example, the work item valid mask may comprise 16 bits.

The work item valid mask indicates valid work items in the work group. Valid work items are those work items from the work group which are needed for the execution of the desired tasks or instances as part of the desired compute workload. In other words, valid work items are those work items, the data for which is to be sent across the interface from the compute requesting unit to the computation sequencing unit. The valid work item mask 501 therefore indicates which work items of the work group are to be sent to the computation execution unit to be used as part of the compute workload.

The work item valid mask is created in dependence on the number of work items in the work group and the locations of work items in the work group. Specifically, the work item valid mask may be created in dependence on the locations (or positions) of the valid work items within the work group. Creating the work item valid mask may comprise assigning a value of 1 to each bit of the work item valid mask which corresponds to the position of a valid work item in the work group. The work group 201 comprises eight work items. The work item valid mask 501 created for the work group 201 therefore contains 8 bits which have been assigned a value of 1, indicating that all eight of the work items in the work group 201 are valid. The remaining 56 bits of the work item valid mask 501 are assigned a value of 0. According to this example, all of the work items 202a to 202h in the work group 201 are valid work items. The valid work items 202a to 202h therefore form a contiguous group of work items. Creating the work item valid mask 501 therefore comprises assigning a value of 1 to the q least significant bits of the work item valid mask. In the example seen in figure 5, q is equal to 8, which is the number of valid work items in the work group. As will be explained in more detail below, for valid work items in a work group which do not form a contiguous group, the work item valid mask may be formed in a different way.

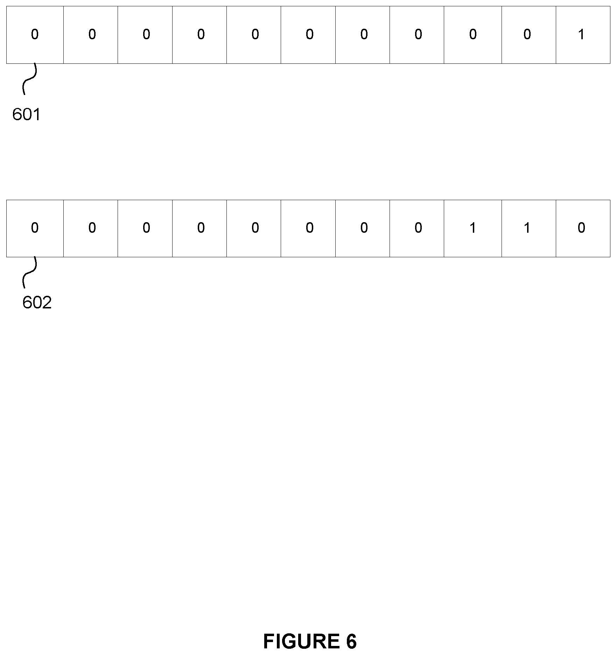

Compressing the work item coordinate data further comprises computing swizzle masks. Figure 6 illustrates a first swizzle mask 601 and a second swizzle mask 602. In the example illustrated in figures 2 to 4, the work group 201 is a two-dimensional work group. A swizzle mask is computed for each dimension of the work group. Thus the method involves generating a first swizzle mask 601 corresponding to the first dimension of the work group 201 and a second swizzle mask 602 corresponding to the second dimension of the work group 201. As will be explained in more detail below, the first swizzle mask 601 indicates which bit(s) of a swizzle index for each work item in the work group correspond to the value of a first coordinate for that work item. The second swizzle mask 602 indicates which bit(s) of the swizzle index for each work item in the work group correspond to the value of a second coordinate for that work item. According to the example seen in figure 6, each swizzle mask contains 11 bits.

Each of the swizzle masks is computed in dependence on a size of the work group in one of the dimensions of the work group. As will be explained in more detail below, work groups may have more than two dimensions. Therefore according to other examples, compressing work item coordinate data may involve computing more than two swizzle masks. Generally, for a work group having n dimensions, compressing the work item coordinate data may comprise computing n swizzle masks, each of the swizzle masks indicating which bit(s) of the swizzle index for each work item in the work group correspond to the value of a respective one of the n coordinates for that work item. The method may comprise computing an n^{th} swizzle mask indicating which bits of the swizzle index for each work item in the work group correspond to the value of an n^{th} coordinate for that work item.

Each of the swizzle masks is computed in dependence on the order by which the work item indices are assigned to the work group. As previously described, the work group 201 has work item indices which are assigned to the work group using the linear order. Swizzle masks 601 and 602 are therefore computed taking into account the linear order of work item indices.

Swizzle mask 601 is computed in dependence on the size of the work group 201 in the first dimension (the x dimension) of the work group 201. The size of work group 201 in the first dimension is two. As will be explained in more detail below, swizzle masks may be computed differently for work groups having a size in the first dimension that is not a power of two. Computing the first swizzle mask 601 comprises assigning a value of 1 to the m least significant bits of the first swizzle mask, wherein m is the number of bits required to represent a maximum value of the first coordinate for the work items in the work group and assigning a value of 0 to the remaining bits of the first swizzle mask. The bits required to represent a maximum value of the first coordinate for the work items in the work group are herein represented using x₀, x₁, x₂...xₘ. For work items 202 in the work group 201, the maximum value of the first (x) coordinate is 1, as illustrated in figure 2. The number of bits required to represent this maximum value is therefore 1 bit. Thus in the swizzle mask 601, the least significant (1) bit has been assigned a value of 1. In other words, in the present example, m = 1. In other words, only one bit (x₀) is required to represent a maximum value of the first coordinate for the work items in the work group. The remaining bits have been assigned a value of 0. The maximum value of the first coordinate for the work items in the work group is equal to r -1, where r is the number of distinct work item positions within the work group in the first dimension. In the present example, the number of distinct work item positions within the work group 201 in the first (x) dimension is 2. The maximum value of the first coordinate for the work items in the work group is therefore equal to 1.

Swizzle mask 602 is computed in dependence on the size of the work group in the second dimension (the y dimension) of the work group 201. The size of work group 201 in the second dimension is four. Computing the second swizzle mask 602 comprises assigning a value of 1 to a contiguous set of p bits of the second swizzle mask, wherein p is the number of bits required to represent a maximum value of the second coordinate for the work items in the work group, and wherein the least significant bit of the contiguous set of p bits is the (m+1)th least significant bit of the second swizzle mask; and assigning a value of 0 to the remaining bits of the second swizzle mask. The bits required to represent a maximum value of the second coordinate for the work items in the work group are herein represented using y₀, y₁, y₂...yₚ. For work items 202 in the work group 201, the maximum value of the second (y) coordinate is 3, as illustrated in figure 2. The number of bits required to represent this maximum value is therefore 2 bits. Thus in the second swizzle mask 602, p = 2. In other words, two bits (y₀, y₁) are required to represent a maximum value of the second coordinate for the work items in the work group. The swizzle mask 602 thus includes a contiguous set of 2 bits to which a value of 1 is assigned. The least significant bit of the contiguous set of 2 bits is the 2^{nd} least significant bit of the second swizzle mask (because m=1 in this example). The remaining bits of the second swizzle mask are assigned a value of 0. A value of 1 is given to the least significant bits in the second swizzle mask which are not the same bits which have a value of 1 in the first swizzle mask. In other words, the first and second swizzle masks do not have any bits in common which have a value of 1.

The maximum value of the second coordinate for the work items in the work group is equal to z -1, where z is the number of distinct work item positions within the work group in the second dimension. In the present example, the number of distinct work item positions within the work group 201 in the second (y) dimension is 4. The maximum value of the second coordinate for the work items in the work group 201 is therefore equal to 3.

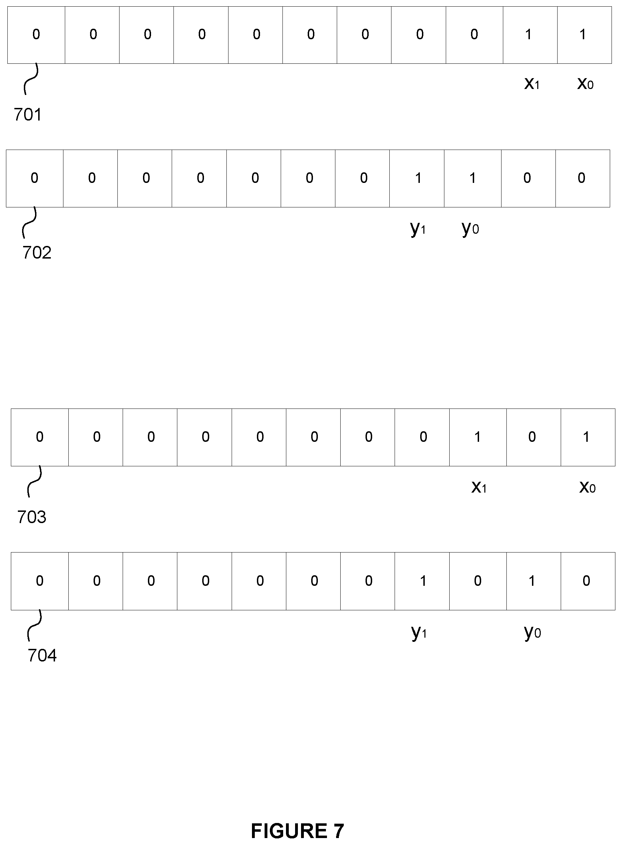

Each of the swizzle masks is computed in dependence on the order by which the work item indices are assigned to the work group. As described above, figure 3 illustrates a work group 301 which may be assigned work item indices using two different orders: a linear order (303) and a Morton order (304). Since swizzle masks are computed in dependence on the order by which the work item indices are assigned to the work group, different swizzle masks are computed for the linear order (303) and the Morton order (304), as shown in figure 7.

The swizzle masks 701, 702 are computed for the work group 301 having work item indices assigned using the linear order (303). The first swizzle mask 701 is computed in dependence on the size of the work group in the x dimension. For linear work item indices, computing the first swizzle mask 701 comprises assigning a value of 1 to the m least significant bits of the first swizzle mask, wherein m is the number of bits required to represent a maximum value of the first coordinate for the work items in the work group and assigning a value of 0 to the remaining bits of the first swizzle mask. The size of the work group 301 in the x dimension is four. The maximum value of the x coordinate is 3. The number of bits needed to represent the maximum value for the x coordinate is therefore 2 (m=2). The two bits needed to represent the maximum value for the x coordinate may be expressed as x₀ x₁. In the present example, x₀ and x₁ = 1. The 2 least significant bits (i.e. bits 0 and 1) of the swizzle mask 701 are therefore assigned a value of 1. The remaining bits in the swizzle mask are assigned a value of 0. In other words, the first swizzle mask takes the form 000000000x₁x₀. Generally, the value of xₐ is assigned to bit a of the first swizzle mask.

The second swizzle mask 702 is computed in dependence on the size of the work group in the y dimension. For linear work item indices, a value of 1 is given to the least significant bits in the second swizzle mask which are not the same bits which have a value of 1 in the first swizzle mask. In the example of figure 7, computing the second swizzle mask 702 comprises assigning a value of 1 to a contiguous set of p bits of the second swizzle mask, wherein p is the number of bits required to represent a maximum value of the second coordinate for the work items in the work group, and wherein the least significant bit of the contiguous set of p bits is the (m+1)th least significant bit of the second swizzle mask; and assigning a value of 0 to the remaining bits of the second swizzle mask. The size of the work group 301 in the y dimension is four. The maximum value of the y coordinate is 3. The number of bits needed to represent the maximum value for the y coordinate is therefore 2 (p=2). The two bits needed to represent the maximum value for the y coordinate may be expressed as y₀ y₁. Bits 2 and 3 of the swizzle mask 702 are therefore assigned a value of 1. The remaining bits in the swizzle mask 702 are assigned a value of 0. In other words, the first swizzle mask takes the form 0000000y₁y₀00. Generally, the value of yₐ is assigned to bit m+a of the second swizzle mask.

The first and second swizzle masks do not have any bits in common which have a value of 1. Broadly, for linearly ordered work item indices, the m least significant bits of swizzle mask 701 are assigned a value of 1 so as to represent the maximum value of the x coordinate. The next p least significant bits of swizzle mask 702 (which do not overlap with those of the swizzle mask 701) are assigned a value of 1 so as to represent the maximum value of the y coordinate. The skilled person would understand how swizzle masks for larger work groups having work item indices assigned using the linear order would be computed, i.e. where the number of bits needed to represent the maximum value for the y coordinate is larger than 2.

It will be appreciated that, for linear order work item indices, this pattern of assigning a value of 1 to bits of a swizzle mask may be extended for work groups having n dimensions, where compressing the work item coordinate data may comprise computing n swizzle masks, each swizzle mask indicating which bits of the swizzle index for each work item in the work group correspond to the value of an nth coordinate for that work item. For example for a three dimensional (3D) work group, as explained in more detail below, compressing the work item coordinate data may comprise computing three swizzle masks. The third swizzle mask may be computed in dependence on the size of a linear work group in the z dimension. Computing the third swizzle mask will comprise assigning the next s least significant bits of the third swizzle mask (which do not overlap with those of swizzle mask 501 or those of swizzle mask 502) a value of 1 so as to represent the maximum value of the z coordinate. Generally, the value of zₐ is assigned to bit m+p+a of the third swizzle mask.

The swizzle masks 703, 704 are computed for the work group 301 having work item indices assigned using the Morton order (304). As above, the two bits needed to represent the maximum value for the x coordinate may be expressed as x₀ x₁. Unlike for work item indices assigned using the linear order, for the Morton order (304) the two bits are assigned to alternating bits of the swizzle mask 701. The first bit xₒ is assigned to the least significant bit of the swizzle mask 703. The second bit x₁ is assigned to the third least significant bit of the swizzle mask 703. Bits 0 and 2 of the swizzle mask 703 are therefore assigned a value of 1. The remaining bits in the swizzle mask 703 are assigned a value of 0. In other words, the first swizzle mask takes the form 00000000 x₁0x₀.

The two bits needed to represent the maximum value for the y coordinate may be expressed as y₀ y₁. The two bits are assigned to alternating bits of the swizzle mask 704. For both the linear and Morton orders, the first and second swizzle masks do not have any bits in common which have a value of 1. The first bit y₀ is therefore assigned to the second least significant bit of the swizzle mask 704. The second bit y₁ is assigned to the fourth least significant bit of the swizzle mask 704. Bits 1 and 3 of the swizzle mask 704 are therefore assigned a value of 1. The remaining bits in the swizzle mask 704 are assigned a value of 0. In other words, the second swizzle mask takes the form 0000000 y₁0y₀0.

Broadly, for Morton work item indices, the even bits 0, 2, 4 etc of the first swizzle mask are each assigned the value of a bit required to represent the maximum value of the first coordinate. The least significant bit is assigned to the least significant bit (bit 0) of the swizzle mask 703. For example, where the first coordinate is the x coordinate, bit 0 of the swizzle mask is assigned the value of and bit 2 of the swizzle mask is assigned the value of x₁. It will be appreciated that for larger work groups, where more than two bits are needed to represent the maximum value of the first coordinate, this pattern can be extended e.g. bit 4 is assigned the value of x₂, bit 6 is assigned the value for x₃ etc. More generally, the value of xₐ is assigned to bit 2a of the first swizzle mask. Computing the first swizzle mask comprises assigning a first binary value to the m least significant even bits of the first swizzle mask, wherein m is the number of bits required to represent a maximum value of the first coordinate for the work items in the work group; and assigning a second binary value to the remaining bits of the first swizzle mask, wherein the first binary value is different to the second binary value.

The odd bits 1, 3, 5 etc of the second swizzle mask are each assigned the value of a bit required to represent the maximum value of the second coordinate. The least significant bit y₀ is assigned to the second least significant bit (bit 1) of the swizzle mask 704. For example, where the second coordinate is the y coordinate, bit 1 of the swizzle mask is assigned the value of y₀ and bit 3 of the swizzle mask is assigned the value of y₁. It will be appreciated that for larger work groups, where more than two bits are needed to represent the maximum value of the second coordinate, this pattern can be extended e.g. bit 5 is assigned the value of y₂, bit 7 is assigned the value for y₃ etc. More generally, the value of yₐ is assigned to bit 2a+1 of the second swizzle mask. Computing the second swizzle mask comprises assigning the first binary value the p least significant odd bits of the second swizzle mask, wherein p is the number of bits required to represent a maximum value of the second coordinate for the work items in the work group; and assigning the second binary value to the remaining bits of the second swizzle mask.

It will be appreciated that, for Morton order work item indices, this pattern of assigning a value of 1 to bits of a swizzle mask may be extended for work groups having n dimensions, where compressing the work item coordinate data may comprise computing n swizzle masks, each swizzle mask indicating which bits of the swizzle index for each work item in the work group correspond to the value of an nth coordinate for that work item. For example for a three dimensional (3D) work group, as explained in more detail below, compressing the work item coordinate data may comprise computing three swizzle masks. The third swizzle mask may be computed in dependence on the size of a linear work group in the z dimension. As an example, for a work group having three dimensions, the value of xₐ may be assigned to bit 3a of the first swizzle mask, the value of yₐ may be assigned to bit 3a+1 of the second swizzle mask and the value of zₐ may be assigned to bit 3a+2 of the third swizzle mask.

Returning to the method 401 corresponding to example work group 201, the method 401 further comprises sending the compressed work item coordinate data across the interface 106 between the computation requesting unit 104 and the computation sequencing unit 105. Sending the compressed work item coordinate data comprises sending the work item valid mask 501 and the first and second swizzle masks 601, 602 across the interface to the computation sequencing unit (105).

The method may comprise sending the first swizzle mask and the second swizzle mask across the interface only once for each work group. The method may comprise sending the work item valid mask only once for each work group. However, if the work group comprises more valid work items than can be indicated by the work item valid mask, more than one work item valid mask may be sent across the interface for each work group. Therefore, for a work group which comprises more than a threshold number of work items, at least one further work item valid mask may be created and sent across the interface. The method may comprise creating a further work item valid mask in dependence on the number of work items in the work group and the locations of work items in the work group and sending the further work item valid mask across the interface to the computation sequencing unit.

As previously discussed, the work item valid mask 501 comprises 64 bits and may therefore indicate up to 64 valid work items. Therefore if the work group for which the work item valid mask was created contained more than 64 valid work items, e.g. 100 work items, a second work item valid mask would need to be created. The two work item valid masks would therefore be sent across the interface to the computation requesting unit. In other words, the threshold number of work items may be 64.

By sending at least one work item valid mask, a first swizzle mask and a second swizzle mask across the interface instead of the coordinates of every work item, the number of transactions between the computation requesting unit 102 and processing logic 103 can be reduced. According to one example, the number of transactions needed for a work group of 128 instances is reduced from 128 to 5. As such, this may drastically increase the rate at which the instances can be executed.

The coordinates for each work item to be executed may be computed by the processing logic 103 upon receiving the compressed work item coordinate data. The compressed work item coordinate data comprises the work item valid mask and the swizzle masks, which are sent across the interface. The compressed work item coordinate data is received and decompressed by the processing logic 103.

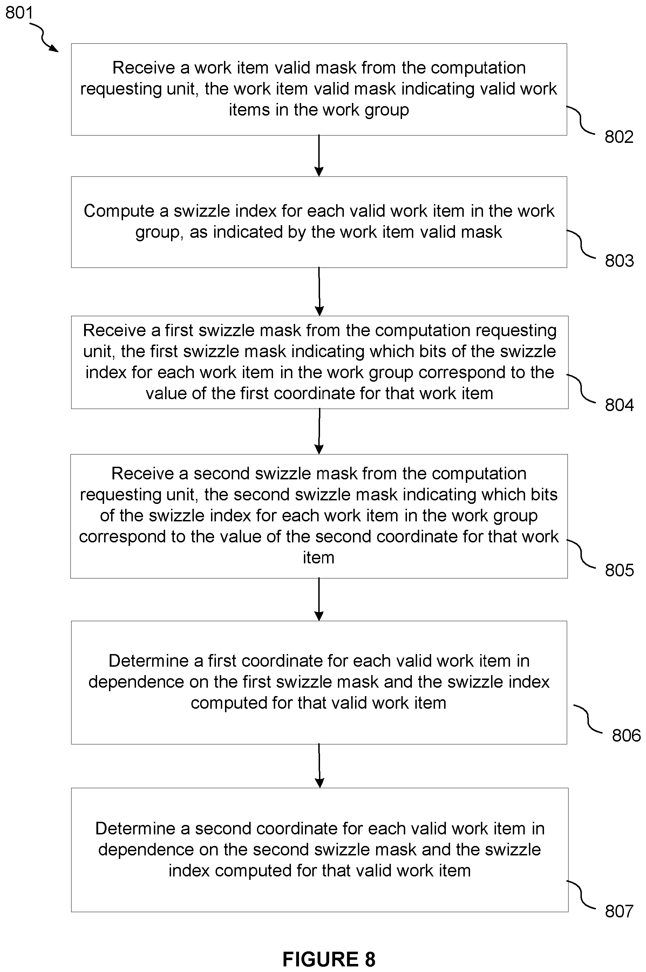

The method for receiving compressed work item coordinate data for work items in a work group across the interface between the computation requesting unit and the computation sequencing unit and decompressing the compressed work item coordinate data is shown in figure 8. The method 801 comprises receiving the work item valid mask (802), the first swizzle mask and the second swizzle mask from the computation requesting unit (804, 805); computing a swizzle index for each valid work item in the work group as indicated by the work item valid mask (803); determining a first coordinate for each valid work item in dependence on the first swizzle mask and the swizzle index computed for that valid work item (806); and determining a second coordinate for each valid work item in dependence on the second swizzle mask and the swizzle index computed for that valid work item (807). The method 801 is performed by the processing logic 103 including the computation sequencing unit 104 and the computation execution unit 105.

Returning to the present example, the computation sequencing unit 104 of processing logic 103 receives from the computation requesting unit 102, the first swizzle mask 601, the second swizzle mask 602 and the work item valid mask 501. The first step performed by the processing logic 103 to decompress the data received across the interface is to compute a swizzle index for each valid work item in the work group.

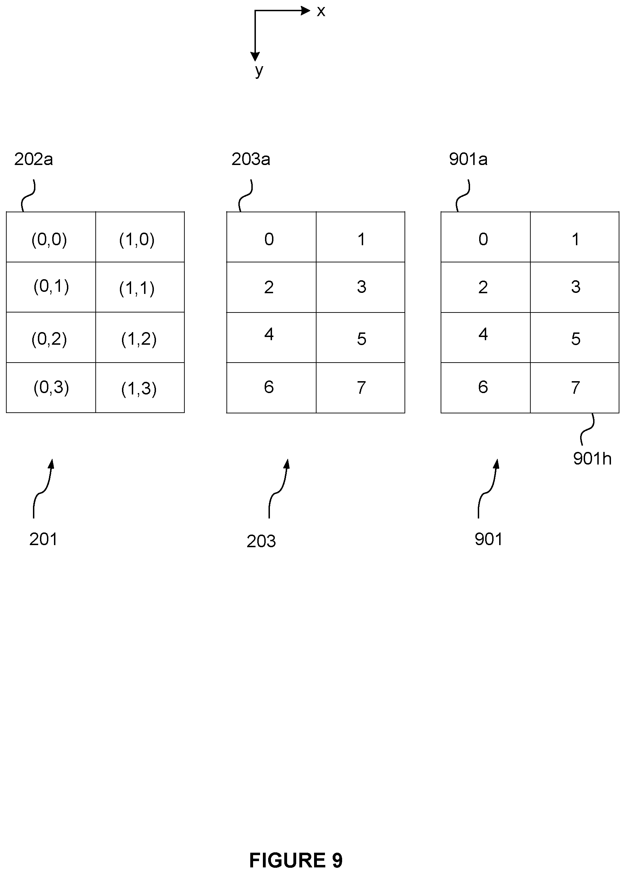

As previously described with respect to figure 2, each work item 202 can be associated with a work item index 203, the work item indices 203 indicating the order of work items in the work group. Figure 9 illustrates the same work group 201 and the associated work item indices 203. Figure 9 further illustrates the swizzle indices 901 associated with each of the work items in the work group 201. Each work item in the work group is identifiable with a swizzle index.

Each work item 202 in the work group 201 is associated with a swizzle index 901 (901a to 901h). The number of swizzle indices 901 is equal to the number of work items in the work group. In the example of figure 9, there are eight swizzle indices 901 associated with the work group. In the example seen in figure 9, the swizzle index 901a is 0 and is associated with the work item 202a. The swizzle index 901h is 7 and is associated with the work item 202h. In other words, each swizzle index corresponds to a single work item in the work group.

As mentioned, the number of distinct work item positions within the work group 201 in the first dimension is equal to 2. The number of distinct work item positions within the work group 201 in the first dimension is therefore a power of 2. For work groups for which the number of distinct work item positions within the work group in the first dimension is a power of 2, computing the swizzle index for each valid work item comprises setting the swizzle index as being equal to the work item index for that valid work item. In the example seen in figure 9, the swizzle index for each work item in the work group is the same as the work item index for that work item. The swizzle index for each work item is equal to the work item index for that work item. It is noted that the swizzle indices 901 shown in figure 9 are represented as decimal integers for ease of understanding, but are also representable as binary values. As will become apparent when considering figure 8, the system handles the swizzle indices as binary values.

As will be explained in more detail below, according to other examples in which the number of distinct work item positions within the work group in the first dimension is not a power of 2, the swizzle index may not be equal to the work item index for all work items in the work group.

Once the computation sequencing unit 104 has calculated the swizzle index for each valid work item indicated by the work item valid mask, the computation requesting unit 104 may send the swizzle indices 901 to the computation execution unit 105 along with the first and second swizzle masks 601, 602. The computation sequencing unit 104 may be configured to compute the swizzle index and send the swizzle index to the computation execution unit 105 for up to 16 instances per clock. The swizzle index may be stored in memory at instance granularity in the computation execution unit 105.

Upon receiving the swizzle indices and the swizzle masks, the computation execution unit 105 determines the first coordinate for each valid work item in dependence on the first swizzle mask and the swizzle index computed for that valid work item, and determines a second coordinate for each valid work item in dependence on the second swizzle mask and the swizzle index computed for that valid work item.

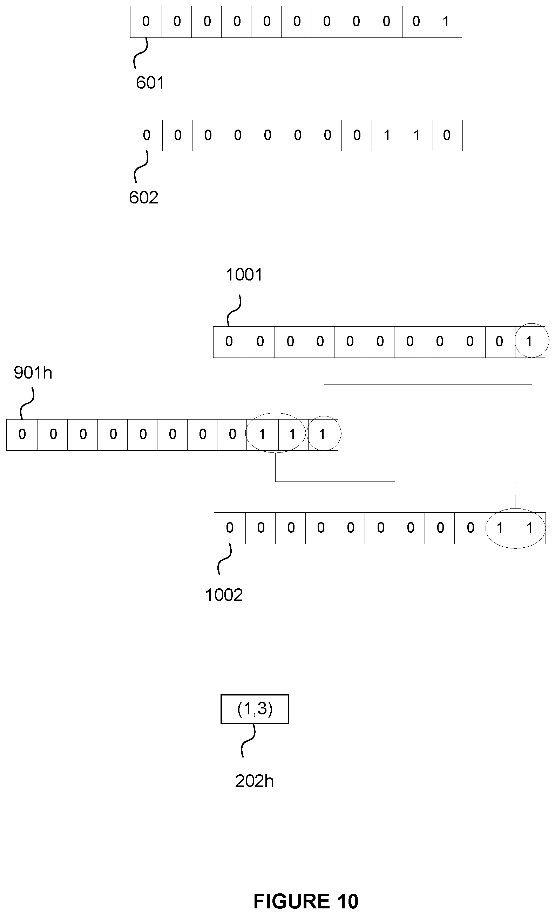

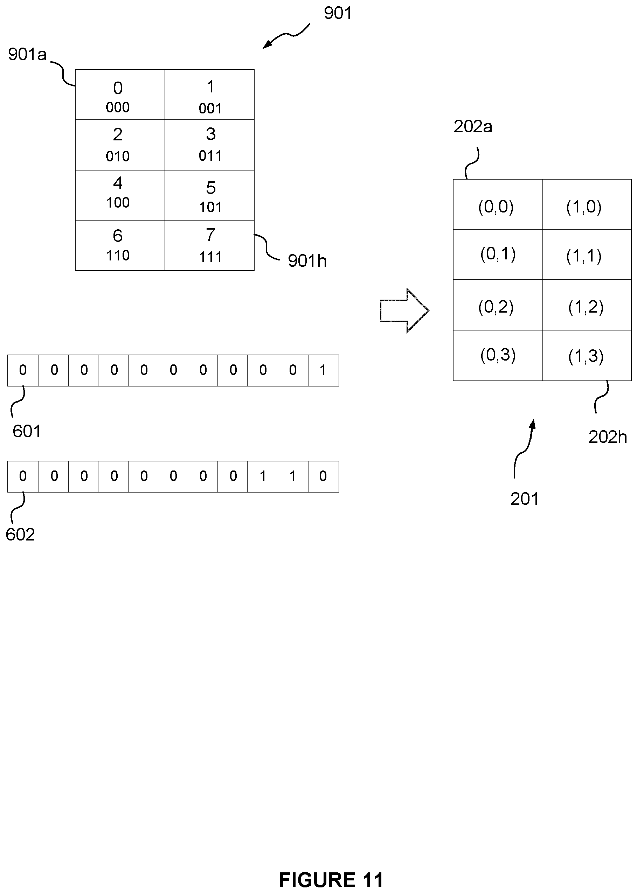

Figure 10 illustrates the process of determining the first and second coordinates for the particular work item 202h. Figure 11 illustrates the first swizzle mask 601, the second swizzle mask 602 and the swizzle index 901h for the work item 202h. The system handles the swizzle indices as binary values and so the swizzle index 901h (shown as being equal to 7 in figure 9) is illustrated as being represented using 3 bits as 111 in figure 10.

Bit string 1001 in figure 10 represents the first coordinate for the work item 202h. Bit string 1002 represents the second coordinate for the work item 202h. The first swizzle mask 601 indicates which bit(s) from the swizzle index 901h are to be taken as the first coordinate 1001 of the work item 202h. The first swizzle mask 601 indicates that the first coordinate 1001 is equal to bit 0 of the swizzle index 901h. The second swizzle mask 602 indicates which bit(s) from the swizzle index 901h are to be taken as the second coordinate 1002 of the work item 202h. The second swizzle mask 602 indicates that the second coordinate 1002 is equal to bits 1 and 2 of the swizzle index 901h. In other words, the swizzle index is a bit string corresponding to a work item in which one or more bits in the string correspond to the value of the first coordinate of the work item and one or more (other) bits in the string correspond to the value of the second coordinate of the work item.

Figure 10 therefore illustrates that the binary value of the first coordinate is 1, while the binary value of the second coordinate is 11. The resulting coordinates are therefore (1,3) for the work item 202h.

Figure 11 illustrates that this process of determining the first and second coordinates may be extended for each work item in the work group 201 using the swizzle indices 901 and the first and second swizzle masks 601, 602. Figure 11 shows how each swizzle index 901 for the work group may be represented using 3 bits as the system handles the swizzle indices as binary values.

The first coordinate for a valid work item is determined as being the value represented by the bit(s) of the swizzle index of that valid work item as indicated by the first swizzle mask. In other words, the first swizzle mask indicates which bit(s) from the swizzle index are to be used to determine the first coordinate of the work item. The bit(s) of the swizzle index indicated by the first swizzle mask form the bit string of the first coordinate.

In the example seen in figure 11, the first swizzle mask 601 indicates which bit(s) from the swizzle index are to be taken as the x coordinate of the work item. Specifically, bits of the first swizzle mask 601 which have been assigned a value of 1 indicate that those bits of the swizzle index are to be used as the x coordinate of the work item. Bits of the second swizzle mask which have been assigned a value of 1 indicate that those bits of the swizzle index are to be used as the y coordinate of the work item. In the example seen in figure 11, the first swizzle mask 601 has a value of 1 at bit 0. The second swizzle mask 602 has a value of 1 at bits 1 and 2.

The first swizzle mask 601 indicates that the least significant bit, bit 0, of the swizzle index of a work item forms the bit string of the x coordinate for that work item. Thus, for work item 202a seen in figure 11, the x coordinate for the work item 202a will be equal to bit 0 of the swizzle index 901a. Therefore, the x coordinate of the work item 202a will be determined to be 0 (00**0**). As per the previous example, for work item 202h, the x coordinate for the work item 202h will be equal to bit 0 of the swizzle index 901h. Therefore, the x coordinate of the work item 202h will be determined to be 1 (111).

The second coordinate for a valid work item is determined as being the value represented by the bit(s) of the swizzle index of that valid work item as indicated by the second swizzle mask. In other words, the second swizzle mask indicates which bit(s) from the swizzle index are to be used to determine the second coordinate of the work item. The bit(s) of the swizzle index indicated by the second swizzle mask form the bit string of the second coordinate.

In the example seen in figure 11, the second swizzle mask 602 indicates which bit(s) from the swizzle index are to be taken as the y coordinate of the work item. Specifically, bits of the second swizzle mask which have been assigned a value of 1 indicate that those bits of the swizzle index are to be used as the y coordinate of the work item. In the example seen in figure 11, the second swizzle mask 602 has a value of 1 at bits 1 and 2.

The second swizzle mask 602 indicates that the second and third least significant bits, bits 1 and 2, of the swizzle index of a work item are to be taken as the value for the y coordinate for that work item. Thus, for work item 202a seen in figure 11, the y coordinate for the work item 202a will be equal to bits 1 and 2 of the swizzle index 901a. Therefore, the y coordinate of the work item 202a will determined to be 0 (**00**0). As per the previous example, for work item 202h, the y coordinate for the work item 202h will be equal to bits 1 and 2 of the swizzle index 901h. Therefore, the y coordinate of the work item 202h will be determined to be 3 (111).

This approach is adopted in order to determine first and second coordinates for each work item in the work group. In the example seen in figure 11, the coordinates for all eight valid work items 202a to 202h in the work group 201 are determined. Once computation execution unit 105 has determined the coordinates of each valid work item in the work group, the computation execution unit 105 accesses the valid work item at the determined coordinates and performs the computation of the valid work item. In other words, the method comprises, for each valid work item in the work group, accessing the valid work item at the first and second coordinates and performing the computation of the valid work item.

The computation sequencing unit 104 may be configured to compute and send to the execution unit 105 the swizzle index for up to 16 instances per clock. The computation execution unit 105 therefore requires 9 cycles to serve 1 task formed of 128 instances. In other words, after 9 cycles the computation execution unit 105 will have the work item coordinates needed for 128 instances. Using the prior methods described which send the work item coordinate data for each work item, at least 128 cycles would be required to gather the work item coordinates needed for 128 instances. It will be appreciated that this method therefore greatly improves the rate at which instances may be scheduled and executed.

It will be appreciated that for the examples so far described, work item coordinate data is compressed and sent across the interface 106 for all work items 202 in the work group 201. All the work items 202a to 202h of the work group 201 are to be sent to the computation sequencing unit to be used as part of the compute workload. In other words, in the example described, all work items 202a to 202h in the work group are valid work items.

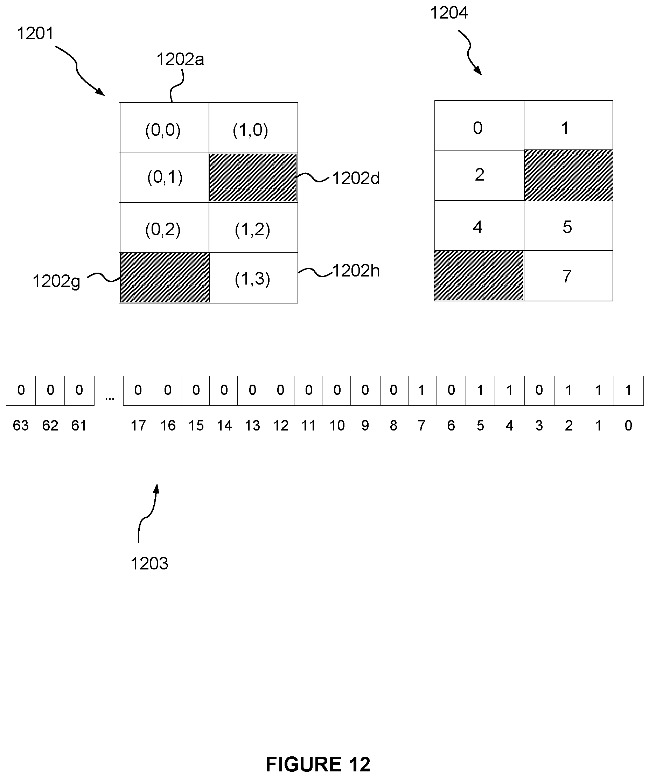

Figure 12 illustrates a work group 1201 having the same dimensions as the work group 201 previously described. Work group 1201 also comprises eight work items 1202. However, in work group 1201, not all eight work items 1202 are valid work items. Non-valid work items are indicated by hatching. Work items 1202a, 1202b, 1202c, 1202e, 1202f and 1202h are valid work items. Work items 1202d and 1202g are non-valid work items. Therefore, information about the coordinates of work items 1202d and 1202g is not compressed and is not sent across the interface to the processing logic 103.

For work groups containing both valid work items and non-valid work items, the work item valid mask will be created so as to reflect this.

Figure 12 illustrates a work item valid mask 1203. The work item valid mask 1203 seen in figure 12 comprises 64 bits. The work item valid mask 1203 thus indicates up to 64 valid work items in the work group. According to another example, the work item valid mask may indicate more or fewer work items in the work group.

The work item valid mask indicates valid work items in the work group. Valid work items are those work items from the work group which are needed for the execution of the desired tasks or instances as part of the desired compute workload. In other words, valid work items are those work items, the data for which is to be sent across the interface from the computation requesting unit to the computation sequencing unit. The valid work item mask therefore indicates which work items of the work group are to be sent to the computation sequencing unit to be used as part of the compute workload.

The work item valid mask is created in dependence on the number of work items in the work group and the locations of work items in the work group. Specifically, the work item valid mask may be created in dependence on the locations of the valid work items within the work group. Creating the work item valid mask may comprise assigning a value of 1 to each bit of the work item valid mask which corresponds to the position of a valid work item in the work group.

The work group 1201 comprises eight work items. The work group 1201 comprises six valid work items. The valid work items in the work group 1201 do not form a single contiguous group of work items. The work item valid mask 1203 created for the work group 1201 therefore contains 6 bits which have been assigned a value of 1. The remaining 58 bits are assigned a value of 0.

According to this example, not all of the work items 1202a to 1202h in the work group 1201 are valid work items. Creating the work item valid mask comprises assigning a value of 1 to each bit of the work item valid mask which corresponds to the position of a valid work item in the work group. Figure 12 further illustrates the work item indices 1204 which are assigned to each work item of the work group 1201, as previously explained. It will be appreciated that the values of the work item indices correspond to the bit number of each bit in the work item valid mask 1203. A bit in the work item valid mask is assigned a value of 1 when the work item having a work item index equal to the bit number of the valid mask, is a valid work item. In the example shown in figure 12, work items 1202a, 1202b, 1202c, 1202e, 1202f and 1202h are valid work items. These work items have work item indices 0, 1, 2, 4, 5 and 7. Therefore bits 0, 1, 2, 4, 5 and 7 of the work item valid mask are assigned a value of 1. The remaining bits of the work item valid mask are assigned a value of 0. Swizzle masks for the work group 1201 are computed using the linear order as previously described.

In examples described herein, a task may contain up to 128 instances from up to 8 work groups. A work item valid mask may therefore indicate valid work items from up to eight different work groups.

As previously described, sending compressed work item coordinate data across the interface 106 comprises sending the work item valid mask 1201 and the first and second swizzle masks 601, 602 across the interface to the computation sequencing unit 104. The compressed work item coordinate data is received and decompressed by the processing logic 103.

Returning to the example illustrated in figure 12, the computation sequencing unit 104 of processing logic 103 receives from the computation requesting unit 102, the first swizzle mask 601, the second swizzle mask 602 and the work item valid mask 1201. The first step performed by the processing logic 103 to decompress the data received across the interface is to compute a swizzle index for each valid work item in the work group. The valid work items in the work group are indicated by the work item valid mask 1201. Thus the computation sequencing unit calculates the swizzle index for each valid work item as indicated by the work item valid mask. The number of distinct work item positions within the work group 1201 in the first dimension is a power of 2. Therefore, computing the swizzle index for each valid work item 1202 comprises setting the swizzle index as being equal to the work item index 1204 for that valid work item. Thus, for the work group 1201, the swizzle index for each work item 1202 in the work group 1201 is the same as the work item index 1204 for that work item. The swizzle index for each work item is equal to the work item index for that work item.

Once the computation sequencing unit 104 has calculated the swizzle index for each valid work item as indicated by the work item valid mask 1203, the computation requesting unit 104 may send the swizzle indices 901 to the computation execution unit 105 along with the first and second swizzle masks 601, 602. Upon receiving the swizzle indices and the swizzle masks, the computation execution unit 105 determines the first coordinate for each valid work item in dependence on the first swizzle mask and the swizzle index computed for that valid work item and a second coordinate for each valid work item in dependence on the second swizzle mask and the swizzle index computed for that valid work item, as previously described.

It will be appreciated that the work groups 201 and 1201 described above have 2 distinct work item positions within the work group in the first dimension (the x dimension). The work group 201 thus has a number of distinct work item positions within the work group in the first dimension that is a power of 2. For work groups having the number of distinct work item positions within the work group in the first dimension being equal to a power of 2, the method for compressing work item coordinate data and sending the compressed work item coordinate data across the interface, receiving the compressed work item coordinate data and decompressing the data is as described above.

For work groups having work item indices assigned using the linear order and a number of distinct work item positions within the work group in the first dimension that is not equal to a power of 2, a slightly different approach is taken. This approach may be referred to herein as the linear corrected mode.

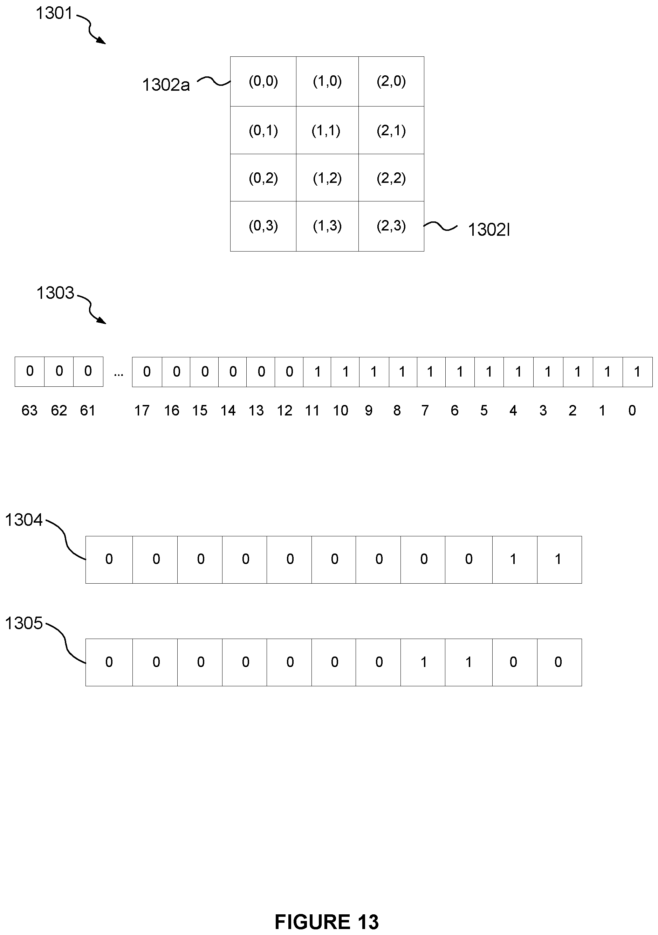

Figure 13 illustrates a work group 1301 comprising a plurality of work items 1302. In the example seen in figure 13, the work group 1301 comprises twelve work items 1302a to 1302I. The work group 1302 seen in figure 13 is a two-dimensional work group. The work group 1302 has a first dimension. In the following example, the first dimension is the x dimension. The work group 1302 has a second dimension. In the following example, the second dimension is the y dimension.

As illustrated in figure 13, each work item has a set of coordinates corresponding to its position within the work group. There are twelve distinct work item positions in work group 1301. For example, work item 1302a has coordinates (0,0). Work item 1302I has coordinates (2,3). The first coordinate of the work item indicates the position of the work item in the work group in the first dimension. The second coordinate of the work item indicates the position of the work item in the work group in the second dimension. The size of the first dimension is equal to the number of distinct work item positions within the work group in the first dimension. The size of the second dimension is equal to the number of distinct work item positions within the work group in the second dimension. The work group 1301 seen in figure 13 has a first dimension of 3. There are three distinct work item positions in the x dimension. The work group 1301 has a second dimension of 4. There are four distinct work item positions in the y direction.

Figure 13 illustrates a work item valid mask 1303 created for the work items 1302 in the work group 1301. The work item valid mask 1303 seen in figure 13 comprises 64 bits. The work item valid mask 1303 is determined in the same way as work item valid mask 501 previously described. Creating the work item valid mask may comprise assigning a value of 1 to each bit of the work item valid mask which corresponds to the position of a valid work item in the work group. The work group 1301 comprises twelve work items. The work item valid mask 1303 created for the work group 1001 therefore contains 12 bits which have been assigned a value of 1. The remaining 52 bits are assigned a value of 0. According to this example, all of the work items 1302a to 1302I in the work group 1301 are valid work items. The valid work items 1302a to 1302I therefore form a contiguous group of work items. Creating the work item valid mask 1301 therefore comprises assigning a value of 1 to the q least significant bits of the work item valid mask. In the example seen in figure 10, q is equal to 12, which is the number of valid work items in the work group.

As per the previous example relating to work group 201, compressing the work item coordinate data further comprises computing swizzle masks. Figure 13 illustrates a first swizzle mask 1304 and a second swizzle mask 1305.

Swizzle mask 1304 is computed based on the size of the work group 1301 in the first dimension (the x dimension). The size of work group 1301 in the first dimension is three.

Swizzle mask 1304 is also computed in dependence on the order by which the work item indices are assigned to the work group. In the present example, the work group 1301 is assigned work group indices using a linear order. The swizzle masks 1304, 1305 are therefore computed in a similar way as swizzle masks 601, 602, 701, 702 previously described. However, work group 1301 comprises three columns i.e. the number of distinct work item positions in the first dimension is three. The work group 1301 thus does not have a number of distinct work item positions within the work group in the first dimension that is a power of 2. Generally, for a work group having a number of distinct work item positions within the work group in the first dimension that is not a power of 2, the first swizzle mask is computed as though the work group had a number of distinct work item positions within the work group in the first dimension that is the next power of 2 that is greater than the actual number of distinct work item positions. Computing the first swizzle mask therefore comprises determining an augmented size of the work group in the first dimension as the smallest value that is a power of two and greater than the number of distinct work item positions within the work group in the first dimension.

For the work group 1301, the next power of 2 greater than the actual number of distinct work item positions is four. In other words, the first swizzle mask is generated as though the work group has four distinct work item positions in the first dimension. The augmented size of the work group 1301 in the first dimension is 4.

Computing the first swizzle mask generally comprises assigning a value of 1 to the m least significant bits of the first swizzle mask, wherein m is the number of bits required to represent a maximum value of the first coordinate for the work items in the work group and assigning a value of 0 to the remaining bits of the first swizzle mask. In this example in which the augmented size of the work group in the first dimension is four, the maximum value of the first (x) coordinate of work items is three The number of bits required to represent this maximum value is therefore 2 bits. Thus in the swizzle mask 1304, the two least significant bits have been assigned a value of 1. In other words, in the present example, m = 2. The remaining bits have been assigned a value of 0. The maximum value of the first coordinate for the work items in the augmented work group is equal to r -1, where r is the number of distinct work item positions within the work group in the first dimension. In the present example, the number of distinct work item positions within the work group 1301 in the first (x) dimension (the augmented size of the work group in the first dimension) is four. The maximum value of the first coordinate for the work items in the work group is therefore equal to 3.

Swizzle mask 1305 is computed based on the size of the work group 1301 in the second dimension (the y dimension). The size of work group 1301 in the first dimension is four.

Computing the second swizzle mask 1305 comprises assigning a value of 1 to a contiguous set of p bits of the second swizzle mask, wherein p is the number of bits required to represent a maximum value of the second coordinate for the work items in the work group, and wherein the least significant bit of the contiguous set of p bits is the (m+1)th least significant bit of the second swizzle mask; and assigning a value of 0 to the remaining bits of the second swizzle mask.

For work items 1302 in the work group 1301, the maximum value of the second (y) coordinate is 3, as illustrated in figure 13. The number of bits required to represent this maximum value is therefore 2 bits. Thus in the second swizzle mask 1305, p = 2. The swizzle mask 1305 thus includes a contiguous set of 2 bits to which a value of 1 is assigned. The least significant bit of the contiguous set of 2 bits is the 3^{rd} least significant bit of the second swizzle mask (because m=2). The remaining bits of the second swizzle mask are assigned a value of 0. A value of 1 is given to the least significant bits in the second swizzle mask which are not the same bits which have a value of 1 in the first swizzle mask. In other words, the first and second swizzle masks do not have any bits in common which have a value of 1. The maximum value of the second coordinate for the work items in the work group is equal to z -1, where z is the number of distinct work item positions within the work group in the second dimension. In the present example, the number of distinct work item positions within the work group 1301 in the second (y) dimension is 4. The maximum value of the second coordinate for the work items in the work group 1001 is therefore equal to 3.

As previously discussed, the method further comprises sending the compressed work item coordinate data across the interface 106 between the computation requesting unit 104 and the computation sequencing unit 105. Sending the compressed work item coordinate data corresponding to work items 1302 comprises sending the work item valid mask 1303 and the first and second swizzle masks 1304, 1305 across the interface to the computation sequencing unit.

The computation sequencing unit 104 of processing logic 103 receives from the computation requesting unit 102, the first swizzle mask 1304, the second swizzle mask 1305 and the work item valid mask 1303. The first step performed by the processing logic 103 to decompress the data received across the interface is to compute a swizzle index for each valid work item in the work group 1301.

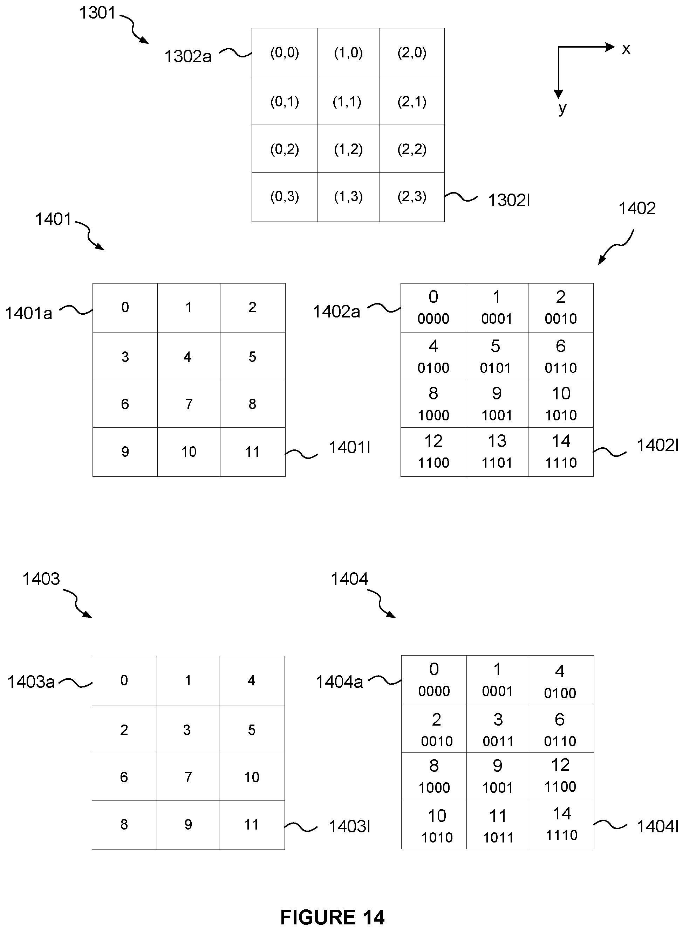

As previously described, each work item 1302 can be associated with a work item index 1401, the work item indices 1401 indicating the order of work items in the work group. Figure 14 shows that work item indices for the work group 1301 can be assigned using the linear order or Morton order. Figure 14 illustrates the same work group 1301 and the associated work item indices assigned using the linear order 1401 and work item indices assigned using the Morton order 1403.

As previously mentioned, for work groups for which the number of distinct work item positions within the work group in the first dimension is a power of 2, computing the swizzle index for each valid work item comprises setting the swizzle index as being equal to the work item index for that valid work item. However, for work groups in which the number of distinct work item positions within the work group in the first dimension is not a power of 2, the swizzle index may not be equal to the work item index for all work items in the work group.

The work group 1301 has three distinct work item positions in the first (x) dimension. Work group 1301 thus does not have a number of distinct work item positions within the work group in the first dimension that is a power of 2. Thus, because the work group does not have a number of distinct work item positions within the work group in the first dimension that is a power of 2, swizzle indices may be assigned using a corrected mode. The swizzle indices may be obtained by applying a swizzle function to the x and y coordinates and the swizzle masks. A reverse of the swizzle function may be used to obtain the work item coordinates from the swizzle indices and the swizzle masks. More specific methods for determining the swizzle indices using a corrected mode are described below.

For work item indices assigned using the linear order (e.g. 1401), the swizzle indices (1402) are assigned using a linear corrected mode. Figure 14 illustrates the swizzle indices 1402 assigned using the linear corrected mode. Each work item in the work group is identifiable with a swizzle index. Each work item 1302 in the work group 1301 is associated with a swizzle index 1402 (1402a to 14012I). The number of swizzle indices 1402 is equal to the number of work items in the work group. In the example of figure 14, there are twelve swizzle indices 1402 associated with the work group. In the example seen in figure 14, the swizzle index 1402a is 0 and is associated with the work item 1302a. The swizzle index 1402I is 14 and is associated with the work item 1302I.

Because the number of distinct work item positions within the work group 1301 in the first dimension is not a power of 2, the swizzle index may not be equal to the work item index for all work items in the work group. For one or more of the valid work items in the work group, the swizzle index is computed for that valid work item to be not equal to the work item index for that valid work item. As illustrated in figure 14, for work items in the first row of the work group (y=0), the swizzle indices are equal to the work item indices for those work items. Swizzle indices 1402a, 1402b and 1402c are equal to work item indices 1401a, 1401b and 1401c, respectively. However, for work items in the second, third and fourth rows of the work group (y=1, y=2, y=3), the swizzle indices are not equal to the work item indices for those work items.

Instead, in the example shown in Figure 14, each work item in the first column (x=0), is assigned a swizzle index that is a multiple of 4. More generally, the maximum value of the first x coordinate in the work group is xₘₐₓ, and the smallest power of two that is greater than xₘₐₓ can be denoted K. Then each work item in the first column (x=0), is assigned a swizzle index that is a multiple of K. In the example shown in Figure 14, xₘₐₓ = 2 and K = 4. For row Y of the work group, the work item in the first column (x=0) is assigned a swizzle index equal to YK and the other work items in the row are assigned swizzle indices which increase in consecutive integers from the swizzle index of the work item in the first column.

This technique can be thought of more generally with respect to work group 1301 as assigning swizzle indices to each of the three columns of the work group using the linear order as if the work group included four columns. In other words, swizzle indices are assigned to each work item as if the work group had a number of distinct work item positions within the work group in the first dimension that is the next power of 2 that is greater than the actual number of distinct work item positions. According to this example, the work group 1301 has three distinct work item positions in the first dimension and the swizzle indices are assigned as if the work group had four distinct work item positions in the first dimension (where the fourth work item position in each row is missing).

For work item indices assigned using the Morton order (e.g. 1403), the swizzle indices (1404) are assigned using a Morton corrected mode. For work groups having work item indices assigned using the Morton order, a Morton corrected mode for assigning swizzle indices is utilised when either the number of distinct work item positions within the work group in the first dimension or the number of distinct work item positions within the work group in the second dimension are not equal to a power of 2. The Morton corrected mode technique can be thought of more generally with respect to the work group 1301 as assigning swizzle indices to each of the three columns of the work group using the Morton order as if the work group included four columns. In other words, swizzle indices are assigned to each work item as if: (i) the work group had a number of distinct work item positions within the work group in the first dimension that is the next (i.e. the minimum) power of 2 that is greater than or equal to the actual number of distinct work item positions within the work group in the first dimension, and (ii) the work group had a number of distinct work item positions within the work group in the second dimension that is the next (i.e. the minimum) power of 2 that is greater than or equal to the actual number of distinct work item positions within the work group in the second dimension. According to this example, the work group 1301 has three distinct work item positions in the first dimension and the swizzle indices are assigned as if the work group had four distinct work item positions in the first dimension (where the fourth work item position in each row is missing).

For both linear corrected and Morton corrected modes, when the number of distinct work item positions within the work group in the first dimension is not a power of two, the swizzle index for each work item is computed as being equal to the work item index for that work item in a reference work group, the reference work group having an augmented size. The reference work group has a number of distinct work item positions in the first dimension equal to the next power of 2 that is greater than the number of distinct work item positions in the first dimension within the work group. In other words, the augmented size includes a number of distinct work item positions in the first dimension which is equal to the next power of 2 that is greater than the number of distinct work item positions in the first dimension within the work group.
Swizzle masks for use in the Morton corrected mode are computed in dependence on the order by which the work item indices are assigned to the work group. Swizzle masks for use with work items 1403 indexed using the Morton order are therefore computed in a similar way as swizzle masks 703, 704 previously described. However, for a work group having a number of distinct work item positions within the work group in the first dimension that is not a power of 2, the first swizzle mask is computed as though the work group had a number of distinct work item positions within the work group in the first dimension that is the next power of 2 that is greater than the actual number of distinct work item positions within the work group in the first dimension. Similarly, for a work group having a number of distinct work item positions within the work group in the second dimension that is not a power of 2, the first swizzle mask is computed as though the work group had a number of distinct work item positions within the work group in the second dimension that is the next power of 2 that is greater than the actual number of distinct work item positions within the work group in the second dimension. Computing the first swizzle mask therefore comprises determining an augmented size of the work group in the first dimension as the smallest value that is a power of two and greater than the number of distinct work item positions within the work group in the first dimension. With respect to the second swizzle mask, for a work group with work item indices assigned using the Morton order: (i) if the work group has a number of distinct work item positions within the work group in the first dimension that is not a power of 2, the second swizzle mask is computed as though the work group had a number of distinct work item positions within the work group in the first dimension that is the next power of 2 that is greater than the actual number of distinct work item positions within the work group in the first dimension, and (ii) if the work group has a number of distinct work item positions within the work group in the second dimension that is not a power of 2, the second swizzle mask is computed as though the work group had a number of distinct work item positions within the work group in the second dimension that is the next power of 2 that is greater than the actual number of distinct work item positions within the work group in the second dimension.

Returning to the linear corrected mode example (work item indices 1401 and swizzle indices 1402), once the computation requesting unit 104 has calculated the swizzle index 1402 for each valid work item 1302 as indicated by the work item valid mask, the computation requesting unit 104 may send the swizzle indices 1402 to the computation execution unit 105 along with the first and second swizzle masks 1304, 1305. Upon receiving the swizzle indices and the swizzle masks, the computation execution unit 105 determines the first and second coordinates for each valid work item in the manner previously discussed.

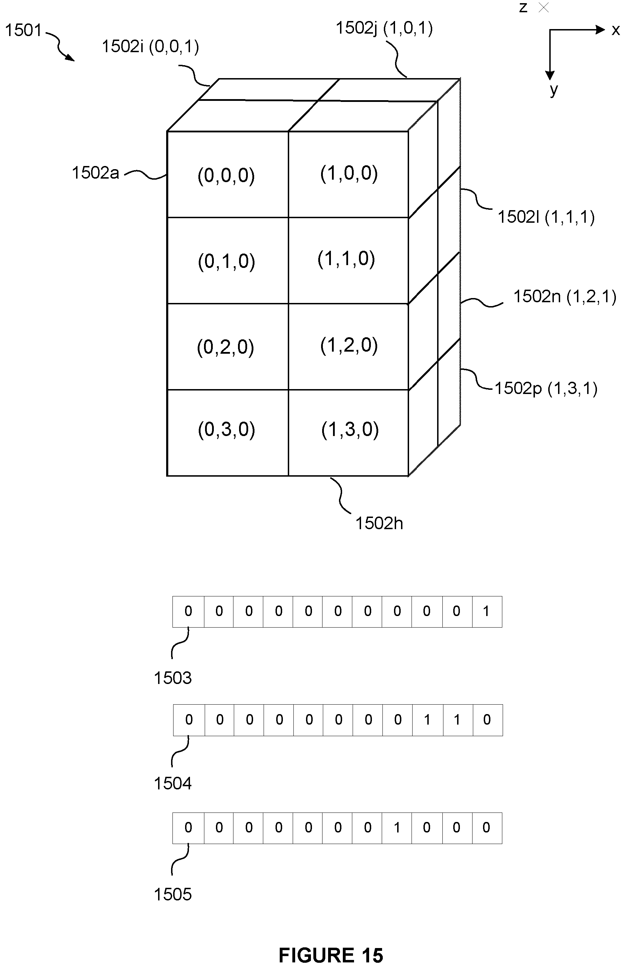

The work groups described thus far have been two-dimensional (2D) work groups, however the methods described may be applied equally to three-dimensional (3D) work groups, or even more generally to n-dimensional work groups. Figure 15 illustrates a three-dimensional work group 1501. In the example seen in figure 15, the work group 1501 comprises sixteen work items 1502a to 1502p. The work group 1502 has a first dimension. In the following example, the first dimension is the x dimension. The work group 1502 has a second dimension. In the following example, the second dimension is the y dimension. The work group has a third dimension. In the following example, the third dimension is the z dimension.

There are 16 distinct work item positions in work group 1501. For example, work item 1502a has coordinates (0,0,0). Work item 1502p has coordinates (1,3,1). The first coordinate of the work item indicates the position of the work item in the work group in the first dimension. The second coordinate of the work item indicates the position of the work item in the work group in the second dimension. The third coordinate of the work item indicates the position of the work item in the work group in the third dimension. The size of the first dimension is equal to the number of distinct work item positions within the work group in the first dimension. The size of the second dimension is equal to the number of distinct work item positions within the work group in the second dimension. The size of the third dimension is equal to the number of distinct work item positions within the work group in the third dimension. The work group 1501 seen in figure 15 has a first dimension of 2. There are two distinct work item positions in the x dimension. The work group 1501 has a second dimension of 5. There are four distinct work item positions in the y dimension. The work group 1501 has a third dimension of 2. There are two distinct work item positions in the z dimension.

As previously mentioned with regard to figure 7, for work groups having n dimensions, compressing the work item coordinate data may comprise computing n swizzle masks, each swizzle mask indicating which bits of the swizzle index for each work item in the work group correspond to the value of an nth coordinate for that work item. Each swizzle mask is computed in dependence on the size of the work group in one dimension and in dependence on the order by which the work item indices are assigned to the work group. According to the example work group 1501 seen in figure 15, work item indices of this work group are assigned using the linear order.

3D work groups may therefore be processed by generating and sending three swizzle masks. Compressing the work item coordinate data may thus comprise generating three swizzle masks 1503, 1504 and 1505 seen in figure 15 using the linear order method previously described. All three swizzle masks 1503, 1504 and 1505 may therefore be sent from the computation requesting unit 104 to the computation execution unit 105 and the computation execution unit 105 may determine the first, second and third coordinates for each valid work item in the manner previously discussed.

According to the present invention, 3D work groups may alternatively be processed by slicing the 3D work group into 2D slices. The computation requesting unit 102 may slice the 3D work group into 2D slices. For example, 3D work group 1501 may be sliced into two slices (z=0, z=1). In other words, work items 1502a to 1502h may form a first 2D slice. Work items 1502i to 1502p may form a second 2D slice. Each 2D slice of the work group may be handled in the same way as previously described with respect to 2D work groups in order to compress and subsequently decompress x and y coordinates for each work item in the work group slice. Using this approach, work item indices associated with each work item in the work group will be used to indicate the order of work items in the work group slice. The number of work item indices is therefore not equal to the number of work items in the work group. In the example seen in figure 15, work item indices 0,1,2,3,4,5,6 and 7 will be associated with each slice of the 3D work group. Using this approach to compress and decompress the x and y coordinates of each work item in the work group 1501, work items 1502a and 1502i are associated with a work item index of 0. Work item 1502h and 1502p are associated with a work item index of 7.

When the 3D work group is sliced into 2D slices, only swizzle masks 1503 and 1504 corresponding to the x and y coordinates may be computed and sent to the computation execution unit 105. According to this example, the z coordinate for each work item in the work group 1501 may be sent to the computation execution unit 105 using a different approach.

According to another example, swizzle masks may be computed with respect to the x and z coordinates (1503 and 1505) or y and z coordinates (1504 and 1505) of the work items in the work group. When swizzle masks are computed with respect to the x and z coordinates for a work item, the y coordinate for the work item may be sent to the computation execution unit a different approach. When swizzle masks are computed with respect to the y and z coordinates for a work item, the x coordinate for the work item may be sent to the computation execution unit a different approach.

One approach to sending coordinates for which swizzle masks are not computed may involve sending those coordinates to the computation execution unit without performing any compression. For example, the z coordinate for each work item in the work group 1501 may be sent across the interface from the computation requesting unit 102 to the processing logic 103 without being compressed. Adopting this approach has at least some of the aforementioned advantages over conventional approaches which involve sending all three uncompressed coordinates for each work item across the interface.

As previously discussed, work groups may be packed into tasks to be executed at the computation execution unit 105. When a 3D work group is sliced into 2D slices, more than one 2D slice may be packed into a single task. The computation requesting unit 102 has the capability of accumulating up to 8 different 2D slices in a task. According to a particular example, each task may contain up to 128 instances. According to this example, if the 2D slice contains more than 64 instances, only one slice may be packed into a single task. However, if the 2D slice contains fewer than 65 instances, more than one 2D slice may be packed into a single task. Work items from different 2D slices in a single task may be differentiated by their work item z coordinate.

The computation requesting unit 102 may assign a base z coordinate to all of the work items in a single work group. Additionally, each slice of the work group is associated with its own z coordinate. A work item in a 2D slice will thus have a z coordinate equal to the base z coordinate for the work group plus the z coordinate for the slice. Therefore, for a task containing a single 2D slice of a work group, each work item in the task will have the same z coordinate. For a task containing at least two different 2D slices, work items from different slices will have different z coordinates. In this way, different 2D slices may be packed into a single task.

The examples described herein relate to compression and decompression of work item coordinates for work items relating to any type of data, e.g. graphics data which may be processed to generate image data.

It is noted that the meaning of the binary values (0 and 1) in the masks (e.g. the swizzle masks and the work item valid mask) may be switched in different implementations.

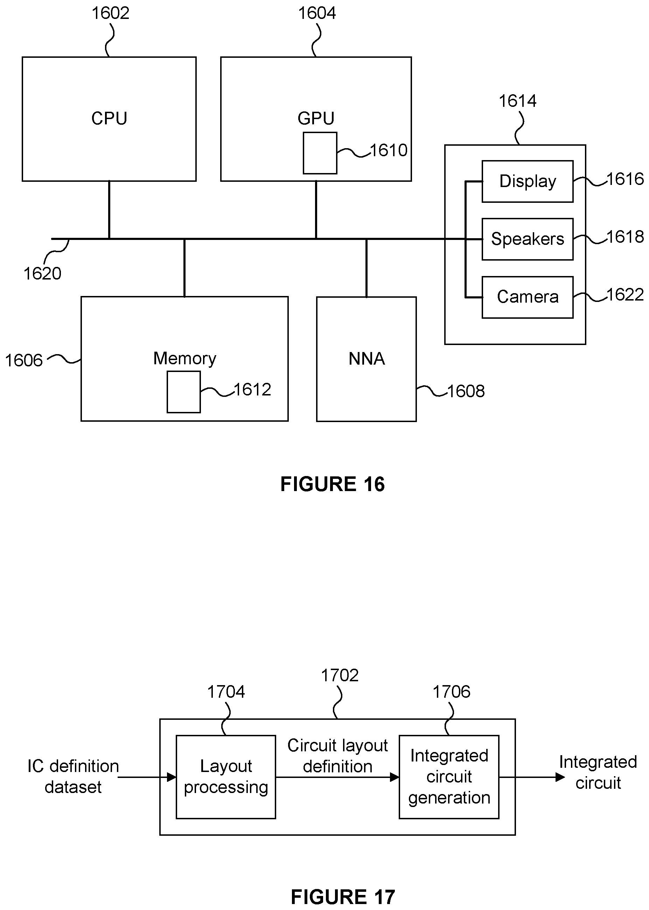

Figure 16 shows a computing system in which the GPU described herein may be implemented. The computing system comprises a CPU 1602, a GPU 1604, a memory 1606, a neural network accelerator (NNA) 1608 and other devices 1614, such as a display 1616, speakers 1618 and a camera 1622. A processing block 1610 is implemented on the GPU 1604. The processing block 1610 may include the computation units seen in figure 1. In other examples, one or more of the depicted components may be omitted from the system, and/or the processing block 1610 may be implemented on the CPU 1602 or within the NNA 1608. The components of the computing system can communicate with each other via a communications bus 1620. A store 1612 is implemented as part of the memory 1606.

The computation requesting unit 102 and processing logic 103 (including computation scheduling unit 104 and computation execution unit 105) of Figures 1 are shown as comprising a number of functional blocks. This is schematic only and is not intended to define a strict division between different logic elements of such entities. Each functional block may be provided in any suitable manner. It is to be understood that intermediate values described herein as being formed by units of the GPU need not be physically generated by the GPU at any point and may merely represent logical values which conveniently describe the processing performed by the GPU between its input and output.

The computation units described herein may be embodied in hardware on an integrated circuit. The computation units described herein may be configured to perform any of the methods described herein. Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computing system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computing system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture a computing system configured to perform any of the methods described herein, or to manufacture a computing system comprising any apparatus described herein. An integrated circuit definition dataset may be, for example, an integrated circuit description.

Therefore, there may be provided a method of manufacturing, at an integrated circuit manufacturing system, a computing system as described herein. Furthermore, there may be provided an integrated circuit definition dataset that, when processed in an integrated circuit manufacturing system, causes the method of manufacturing a computing system to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

An example of processing an integrated circuit definition dataset at an integrated circuit manufacturing system so as to configure the system to manufacture a computing system will now be described with respect to Figure 17.

Figure 17 shows an example of an integrated circuit (IC) manufacturing system 1702 which is configured to manufacture a computing system as described in any of the examples herein. In particular, the IC manufacturing system 1702 comprises a layout processing system 1704 and an integrated circuit generation system 1706. The IC manufacturing system 1702 is configured to receive an IC definition dataset (e.g. defining a computing system as described in any of the examples herein), process the IC definition dataset, and generate an IC according to the IC definition dataset (e.g. which embodies a computing system as described in any of the examples herein). The processing of the IC definition dataset configures the IC manufacturing system 1702 to manufacture an integrated circuit embodying a computing system as described in any of the examples herein.

The layout processing system 1704 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g. in terms of logical components (e.g. NAND, NOR, AND, OR, MUX and FLIP-FLOP components). A circuit layout can be determined from the gate level representation of the circuit by determining positional information for the logical components. This may be done automatically or with user involvement in order to optimise the circuit layout. When the layout processing system 1704 has determined the circuit layout it may output a circuit layout definition to the IC generation system 1706. A circuit layout definition may be, for example, a circuit layout description.

The IC generation system 1706 generates an IC according to the circuit layout definition, as is known in the art. For example, the IC generation system 1706 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 1706 may be in the form of computer-readable code which the IC generation system 1706 can use to form a suitable mask for use in generating an IC.

The different processes performed by the IC manufacturing system 1702 may be implemented all in one location, e.g. by one party. Alternatively, the IC manufacturing system 1702 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture a computing system without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g. by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 14 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 17, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, reduced latency, increased throughput, and/or reduced power consumption. During manufacture of such devices, apparatus, modules, and systems (e.g. in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

## Claims

1. A method for receiving compressed work item coordinate data for work items in a work group across an interface between a computation requesting unit and a computation sequencing unit and decompressing the compressed work item coordinate data, each work item in the work group being identifiable with a swizzle index, the method comprising:
receiving a work item valid mask from the computation requesting unit, the work item valid mask indicating valid work items in the work group;
computing the swizzle index for each valid work item in the work group, as indicated by the work item valid mask;
receiving a first swizzle mask from the computation requesting unit, the first swizzle mask indicating which bits of the swizzle index for each work item in the work group correspond to the value of a first coordinate for that work item;
receiving a second swizzle mask from the computation requesting unit, the second swizzle mask indicating which bits of the swizzle index for each work item in the work group correspond to the value of a second coordinate for that work item;
determining a first coordinate for each valid work item in dependence on the first swizzle mask and the swizzle index computed for that valid work item; and
determining a second coordinate for each valid work item in dependence on the second swizzle mask and the swizzle index computed for that valid work item.

2. The method according to claim 1, wherein the work group has a first dimension, the first coordinate of a work item indicating the position of the work item in the work group in the first dimension; and wherein the work group has a second dimension, the second coordinate of a work item indicating the position of the work item in the work group in the second dimension.

3. The method according to any preceding claim, wherein each work item in the work group is associated with a work item index, the work item indices indicating the order of work items in the work group.

4. The method according to claim 3, wherein the number of distinct work item positions within the work group in the first dimension is a power of 2, and wherein for each valid work item in the work group, said computing the swizzle index for the valid work item comprises setting the swizzle index as being equal to the work item index for that valid work item, or wherein the number of distinct work item positions within the work group in the first dimension is not a power of two, computing the swizzle index for each work item in the first work item position in the first dimension comprises setting the swizzle index for a work item as being equal to the work item index for that work item in a reference work group, the reference work group having a number of distinct work item positions equal to the next power of 2 that is greater than the number of distinct work item positions within the work group.

5. The method according to claim 2 or 3, wherein the number of distinct work item positions within the work group in the first dimension is not a power of 2, and wherein for one or more of the valid work items in the work group, the swizzle index is computed for that valid work item to be not equal to the work item index for that valid work item, and optionally wherein the swizzle index is computed for each valid work item such that, the swizzle index for a valid work item having a first coordinate of 0 and a second coordinate of Y, is determined to be YK, where K is the smallest power of two that is greater than xₘₐₓ, where xₘₐₓ is the maximum value of the first coordinates of the work items in the work group.

6. The method according to any preceding claim, wherein determining a first coordinate for each valid work item in dependence on the first swizzle mask and the swizzle index computed for that valid work item, comprises determining the first coordinate for a valid work item as being the number represented by the bits of the swizzle index of that valid work item indicated by the first swizzle mask and/or wherein determining a second coordinate for each valid work item in dependence on the second swizzle mask and the swizzle index computed for that valid work item, comprises determining the second coordinate for a valid work item as being the number represented by the bits of the swizzle index of that valid work item indicated by the second swizzle mask.

7. The method according to any preceding claim, wherein the method comprises receiving the first swizzle mask and the second swizzle mask only once for each work group.

8. The method according to claim 2, wherein the work group has a third dimension, wherein a third coordinate of a work item indicates the position of the work item in the work group in the third dimension, and wherein the method comprises:
receiving a third swizzle mask indicating which bits of the swizzle index for each work item in the work group correspond to the value of the third coordinate for that work item; and
determining a third coordinate for each for each valid work item in dependence on the third swizzle mask and the swizzle index computed for that valid work item by determining the third coordinate for a valid work item as being the number represented by the bits of the swizzle index of that valid work item indicated by the third swizzle mask.

9. The method according to any preceding claim, wherein the work item valid mask indicates up to 64 valid work items the work group.

10. The method according to any preceding claim, wherein for a work group comprising more than a threshold number of work items, the method comprises:
receiving a further work item valid mask; and
computing the swizzle index for each valid work item in the work group, as indicated by the work item valid mask or the further work item valid mask.

11. The method according to any preceding claim, wherein the method further comprises, for each valid work item in the work group, accessing the valid work item at the first and second coordinates and sequencing the computation of the valid work item.

12. Processing logic configured to receive compressed work item coordinate data for work items in a work group across an interface from a computation requesting unit and decompress the compressed work item coordinate data, each work item in the work group being identifiable with a swizzle index, the processing logic being configured to:
receive a work item valid mask from the computation requesting unit, the work item valid mask indicating valid work items in the work group;
compute the swizzle index for each valid work item in the work group, as indicated by the work item valid mask;
receive a first swizzle mask from the computation requesting unit, the first swizzle mask indicating which bits of the swizzle index for each work item in the work group correspond to the value of a first coordinate for that work item;
receive a second swizzle mask from the computation requesting unit, the second swizzle mask indicating which bits of the swizzle index for each work item in the work group correspond to the value of a second coordinate for that work item;
determine a first coordinate for each valid work item in dependence on the first swizzle mask and the swizzle index computed for that valid work item; and
determine a second coordinate for each valid work item in dependence on the second swizzle mask and the swizzle index computed for that valid work item
and optionally, wherein the processing logic comprises a computation sequencing unit and a computation execution unit, the computation sequencing unit being configured to:
receive a work item valid mask from the computation requesting unit, the work item valid mask indicating valid work items in the work group;
compute the swizzle index for each valid work item in the work group, as indicated by the work item valid mask;
receive a first swizzle mask from the computation requesting unit, the first swizzle mask indicating which bits of the swizzle index for each work item in the work group correspond to the value of a first coordinate for that work item; and
receive a second swizzle mask from the computation requesting unit, the second swizzle mask indicating which bits of the swizzle index for each work item in the work group correspond to the value of a second coordinate for that work item; and
the computation execution unit being configured to:
determine a first coordinate for each valid work item in dependence on the first swizzle mask and the swizzle index computed for that valid work item; and
determine a second coordinate for each valid work item in dependence on the second swizzle mask and the swizzle index computed for that valid work item.

13. A computing system comprising:
the processing logic according to claim 12; and
a computation requesting unit, the computation requesting unit being configured to:
create the work item valid mask in dependence on the number of work items in the work group and the positions of work items in the work group, the work item valid mask indicating valid work items in the work group;
compute the first swizzle mask indicating which bits of the index for each work item in the work group correspond to the value of a first coordinate for that work item;
compute the second swizzle mask indicating which bits of the index for each work item in the work group correspond to the value of a second coordinate for that work item; and
send the first and second swizzle masks and the work item valid mask across the interface to the computation sequencing unit.

14. A computer readable storage medium having encoded thereon computer readable code configured to cause the method of any of claims 1 to 11 to be performed when the code is run.

15. An integrated circuit definition dataset that, when processed in an integrated circuit manufacturing system, configures the integrated circuit manufacturing system to manufacture processing logic as claimed in claim 12or a computing system as claimed in claim 13.
